# EUROPEAN PATENT APPLICATION

(11) **EP 4 658 043 A1**
(43) Date of publication of application: **03.12.2025**
(21) Application number: 23959266.0
(22) Date of filing: 24.11.2023
(51) Int. Cl.: H10K 59/12

(54) **DISPLAY SUBSTRATE AND DISPLAY PANEL**

(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: XU, Guanghua, Beijing 100176 (CN); FAN, Cong, Beijing 100176 (CN); ZHANG, Wei, Beijing 100176 (CN); HE, Fan, Beijing 100176 (CN); CHAI, Mingzhi, Beijing 100176 (CN); DU, Lili, Beijing 100176 (CN); DONG, Xiangdan, Beijing 100176 (CN); XIE, Taofeng, Beijing 100176 (CN); WANG, Hongli, Beijing 100176 (CN)
(74) Representative: Cohausz & Florack
(86) International application number: PCT/CN2023/134029
(87) International publication number: WO 2025/107296

(57) **Abstract**

A display substrate is provided to include a driving substrate, and a planarization layer, an insulating layer, and a pixel defining layer, which are sequentially stacked on one side of the driving substrate; the planarization layer includes first climbing regions where a size of the planarization layer in a first direction gradually increases from 0 to a maximum value, and the first direction is a direction of the planarization layer away from the driving substrate; an orthographic projection of the first climbing regions on the driving substrate and an orthographic projection of the pixel defining layer on the driving substrate at least partially do not overlap with each other; and the insulating layer includes at least one boundary, and an orthographic projection of at least part of the boundary of the insulating layer on the driving substrate is outside that of the first climbing regions on the driving substrate.

## Description

### TECHNICAL FIELD

The present disclosure relates to the field of display technology, in particular to a display substrate and a display panel.

### BACKGROUND

An organic light-emitting diode (OLED) display screen attracts extensive attention due to its advantages of self-luminescence, low power consumption, lightness, thinness, flexibility, gorgeous color, high contrast, and fast response.

### SUMMARY

In a first aspect, an embodiment of the present disclosure provides a display substrate, including a driving substrate, a planarization layer, an insulating layer, and a pixel defining layer, wherein the planarization layer, the insulating layer, and the pixel defining layer are sequentially stacked on one side of the driving substrate; the planarization layer includes a plurality of first climbing regions where a size of the planarization layer in a first direction gradually increases from 0 to a maximum value, and the first direction is a direction of the planarization layer away from the driving substrate; an orthographic projection of the plurality of first climbing regions on the driving substrate and an orthographic projection of the pixel defining layer on the driving substrate do not at least partially overlap with each other; and the insulating layer includes at least one boundary, and an orthographic projection of at least part of the boundary of the insulating layer on the driving substrate is located outside an orthographic projection of the plurality of first climbing regions on the driving substrate.

In a second aspect, an embodiment of the present disclosure further provides a display substrate, including a driving substrate, a planarization layer, an insulating layer, and a pixel defining layer, wherein the planarization layer, the insulating layer, and the pixel defining layer are sequentially stacked on one side of the driving substrate; the planarization layer includes a plurality of flat regions and a plurality of first climbing regions, and the plurality of flat regions abut on the plurality of first climbing regions, respectively; an orthographic projection of the plurality of first climbing regions on the driving substrate and an orthographic projection of the pixel defining layer on the driving substrate do not at least partially overlap with each other, a size of the planarization layer in a first direction gradually increases from 0 to a maximum value in the plurality of first climbing regions, a size of the planarization layer at any position in the first direction is approximately the maximum value in the plurality of flat regions, and the first direction is a direction of the planarization layer away from the driving substrate; and the insulating layer includes at least one boundary, and an orthographic projection of at least part of the boundary of the insulating layer on the driving substrate is located in orthographic projection of the plurality of flat regions on the driving substrate, or the orthographic projection of at least part of the boundary of the insulating layer on the driving substrate and an orthographic projection of the planarization layer on the driving substrate do not overlap with each other.

In some embodiments, the display substrate includes a display region, a hole region, and a hole peripheral region, the hole peripheral region at least partially surrounds the hole region, and the display region at least partially surrounds the hole peripheral region; the planarization layer and the pixel defining layer respectively extend from the display region to the hole peripheral region, and the insulating layer is located in the display region and the hole peripheral region; cut-off boundaries of the pixel defining layer, the planarization layer, and the insulating layer are sequentially arranged along a second direction in the hole peripheral region, the cut-off boundaries of the pixel defining layer, the planarization layer, and the insulating layer are boundaries on a side of the pixel defining layer, the planarization layer, and the insulating layer close to the hole region in the hole peripheral region; and the second direction is a direction of the hole peripheral region away from the display region and close to the hole region.

In some embodiments, the insulating layer includes a plurality of partition grooves therein in the hole peripheral region, and the plurality of partition grooves are sequentially arranged at intervals in the second direction and configured to partition the insulating layer into a plurality of partition portions.

In some embodiments, an orthographic projection of each of the plurality of partition grooves on the driving substrate is closed and surrounds the hole region; and an orthographic projection of the plurality of partition grooves on the driving substrate at least partially overlaps with the orthographic projections of the plurality of flat regions on the driving substrate.

In some embodiments, the planarization layer includes the plurality of first climbing regions and the plurality of flat regions in the hole peripheral region, and the plurality of flat regions and the plurality of first climbing regions are sequentially arranged along the second direction; and an orthographic projection of the plurality of partition grooves on the driving substrate is within the orthographic projections of the plurality of flat regions on the driving substrate.

In some embodiments, the insulating layer includes two to five partition grooves.

In some embodiments, the plurality of partition portions have a same width in the second direction.

In some embodiments, the plurality of partition portions have different widths in the second direction.

In some embodiments, a partition portion closest to the hole region is a first partition portion, a partition portion closest to the display region is a second partition portion, and at least one partition portion between the first partition portion and the second partition portion is at least one intermediate partition portion; widths of the first partition portion and the second partition portion in the second direction are greater than a width of the intermediate partition portion in the second direction, respectively, and the width of the second partition portion in the second direction is greater than the width of the first partition portion in the second direction.

In some embodiments, the width of the first partition portion in the second direction is in a range of 81µm to 83µm; the width of the second partition portion in the second direction is in a range of 85µm to 89µm; and the width of the intermediate partition portion in the second direction is in a range of 75µm to 80µm.

In some embodiments, the width of the first partition portion in the second direction is 81µm; the width of the second partition portion in the second direction is 88µm; and the width of the intermediate partition portion in the second direction is 80µm.

In some embodiments, the width of each partition portion in the second direction is not less than 10µm.

In some embodiments, a width of each partition groove in the second direction is less than a width of each partition portion in the second direction.

In some embodiments, the width of each partition groove in the second direction is in a range of 3 µm to 10µm.

In some embodiments, a boundary of the first partition portion close to the hole region is the cut-off boundary of the insulating layer, and a distance between an orthographic projection of the cut-off boundary of the insulating layer on the driving substrate and an orthographic projection of the cut-off boundary of the planarization layer on the driving substrate is greater than or equal to 3.5µm and less than the width of the first partition portion in the second direction.

In some embodiments, a portion of the insulating layer located in the display region and a portion of the insulating layer located in the hole peripheral region are separated from each other in the hole peripheral region, and the orthographic projection of the pixel defining layer on the driving substrate covers at least a part of a separation boundary of the insulating layer.

In some embodiments, a boundary of the second partition portion close to the hole region is located on a side of the cut-off boundary of the pixel defining layer close to the hole region, and a distance between an orthographic projection of the boundary of the second partition portion close to the hole region on the driving substrate and an orthographic projection of the cut-off boundary of the pixel defining layer on the driving substrate is greater than or equal to 3 µm and less than the width of the second partition portion in the second direction.

In some embodiments, the distance between the orthographic projection of the boundary of the second partition portion close to the hole region on the driving substrate and the orthographic projection of the cut-off boundary of the pixel defining layer on the driving substrate is greater than or equal to 5µm.

In some embodiments, the driving substrate includes a substrate, a plurality of conductive layers and a plurality of inorganic insulating layers; the plurality of conductive layers and the plurality of inorganic insulating layers are sequentially and alternately stacked on a side of the substrate close to the planarization layer; the substrate extends from the display region to the hole peripheral region; the plurality of conductive layers are located in the display region, and at least a part of the conductive layers are located in the hole peripheral region; the plurality of inorganic insulating layers extend from the display region to the hole peripheral region; the display substrate further includes a plurality of first isolation pillars, a first dam and a plurality of second isolation pillars, which are located in the hole peripheral region and are sequentially arranged at intervals along the second direction; each of the plurality of first isolation pillars and the plurality of second isolation pillars includes at least one conductive layer; the first dam includes a first sub-layer in the same layer and made of the same material as the planarization layer and a second sub-layer in the same layer and made of the same material as the pixel defining layer, and the first sub-layer and the second sub-layer are sequentially stacked; and the plurality of first isolation pillars, the first dam and the plurality of second isolation pillars are located on a side of the cut-off boundary of the insulating layer close to the hole region, and orthographic projections of the plurality of first isolation pillars, the first dam and the plurality of second isolation pillars on the substrate do not overlap with an orthographic projection of the insulating layer on the substrate.

In some embodiments, a distance between the cut-off boundary of the insulating layer and a boundary of a first isolation pillar closest to the cut-off boundary of the insulating layer is greater than or equal to 4µm.

In some embodiments, the planarization layer includes a plurality of sub-layers, which are sequentially stacked; the display substrate further includes a plurality of first wiring lines in the hole peripheral region and between two adjacent sub-layers, orthographic projections of at least part of the first wiring lines on the driving substrate are located in the plurality of flat regions, and orthographic projections of the plurality of first wiring lines and the plurality of partition grooves on the driving substrate do not overlap with each other.

In some embodiments, a distance between orthographic projections of adjacent boundaries of each first wiring line and the corresponding partition groove on the driving substrate is greater than 1 µm.

In some embodiments, an orthographic projection of the plurality of partition portions on the driving substrate and the orthographic projection of the planarization layer on the driving substrate at least partially overlap with each other; the plurality of partition portions include a plurality of first vents therein, orthographic projections of the plurality of first vents on the driving substrate is located in a region where the orthographic projection of the plurality of partition portions on the driving substrate and the orthographic projection of the planarization layer on the driving substrate at least partially overlap with each other, and the plurality of first vents are uniformly arranged; the display substrate further includes a plurality of first filling structures in the same layer and made of the same material as the pixel defining layer; and the plurality of first filling structures in one-to-one correspondence with the plurality of first vents, and an orthographic projection of each first filling structure on the driving substrate covers the corresponding first vent.

In some embodiments, a distance between corresponding boundaries of orthographic projections of a first filling structure and a first vent corresponding to each other on the driving substrate is greater than or equal to 5µm.

In some embodiments, a shape of the orthographic projection of each first vent on the driving substrate includes a triangle, a rectangle, a circle, an ellipse, or a polygon, and a shape of the orthographic projection of each first filling structure on the driving substrate includes a triangle, a rectangle, a circle, an ellipse, or a polygon.

In some embodiments, an area of the orthographic projection of each first vent on the driving substrate is in a range from 3 × 3µm² to 10 × 10µm².

In some embodiments, the display substrate includes at least one hole region; and each hole region has a shape including a circle, an ellipse, a capsule shape or an inverted trapezoid.

In some embodiments, the display substrate further includes a binding region on one side of the display region, and the binding region includes a first region; at least a part of the conductive layer is located in the first region, and the insulating layer is located in the first region; the display substrate further includes a power electrode located in the first region; the power electrode includes a first conductive pattern and at least one conductive layer, and the at least one conductive layer and the first conductive pattern are sequentially stacked in a direction away from the driving substrate; the first conductive pattern is located on a side of the insulating layer away from the driving substrate and partially overlaps with the insulating layer; and an orthographic projection of the first conductive pattern on the driving substrate covers at least a portion of an overlapping boundary of the insulating layer overlapping with the first conductive pattern, and an orthographic projection of an overlapping boundary of the first conductive pattern overlapping with the insulating layer on the driving substrate is at least partially located in the orthographic projection of the insulating layer on the driving substrate.

In some embodiments, a region where the orthographic projection of the first conductive pattern on the driving substrate overlaps with the orthographic projection of the insulating layer on the driving substrate has a width greater than or equal to 3µm.

In some embodiments, the display substrate further includes a second filling structure in the first region and in the same layer and made of the same material as the pixel defining layer; wherein an orthographic projection of the second filling structure on the driving substrate covers a first boundary of the insulating layer overlapping with the first conductive pattern and a second boundary of the first conductive pattern overlapping with the insulating layer; a distance between an orthographic projection of the first boundary on the driving substrate and an orthographic projection of a boundary of the second filling structure on a side of the first boundary away from the insulating layer on the driving substrate is greater than or equal to 5µm; and a distance between an orthographic projection of the second boundary on the driving substrate and an orthographic projection of a boundary of the second filling structure on a side of the second boundary away from the first conductive pattern on the driving substrate is greater than or equal to 10µm.

In some embodiments, the binding region further includes a second region; at least a part of the conductive layer is located in the second region, and the insulating layer further includes a plurality of partition strips in the second region; the display substrate further includes a power line and a plurality of second dams, at least a part of which are located in the second region; in the second region, the plurality of partition strips and the plurality of second dams extend along a third direction, respectively, and are sequentially and alternately arranged along a fourth direction; the planarization layer and the pixel defining layer further extend to the second region; the plurality of second dams include third sub-layers in the same layer and made of the same material as the planarization layer and fourth sub-layers in the same layer and made of the same material as the pixel defining layer, and the third sub-layers and the fourth sub-layers are sequentially stacked; the power line includes at least one conductive layer, and extends in the fourth direction; the third direction intersects with the fourth direction; an orthographic projection of the power line on the driving substrate intersects with orthographic projections of the plurality of partition strips and the plurality of second dams on the driving substrate; the binding region further includes a passivation layer between the power line and the plurality of partition strips and covering the second region; and an edge region of each partition strip overlaps with the plurality of second dams, the planarization layer, and the pixel defining layer, and a portion of each partition strip other than the edge region is in contact with the passivation layer.

In some embodiments, a width of the edge region of each partition strip overlapping with the pixel defining layer in the fourth direction is greater than or equal to 5µm.

In some embodiments, orthographic projections of the boundaries of the plurality of partition strips on the planarization layer are located in the plurality of flat regions.

In some embodiments, in a region where each partition strip overlaps with a boundary of the power line, a partial boundary of the partition strip extends outward in an extending direction of the boundary of the power line to form a protruding portion, which covers a part of the boundary of the power line.

In some embodiments, a size of the protruding portion in the extending direction of the boundary of the power line is greater than or equal to 5µm.

In some embodiments, the binding region further includes a third region between the display region and the second dam closest to the display region; the planarization layer and the pixel defining layer respectively extend from the display region to the third region, and the insulating layer is further located in the third region; in the third region, cut-off boundaries of the pixel defining layer, the planarization layer, and the insulating layer are sequentially arranged along a fifth direction, and in the third region, the cut-off boundaries of the pixel defining layer, the planarization layer, and the insulating layer are boundaries on a side of the pixel defining layer, the planarization layer, and the insulating layer close to the second dam; and the fifth direction is a direction of the third region away from the display region and close to the second dam.

In some embodiments, in the third region, the orthographic projection of the insulating layer on the driving substrate at least partially overlaps with the orthographic projection of the planarization layer on the driving substrate; the insulating layer includes a plurality of second vents therein, orthographic projections of the plurality of second vents on the driving substrate are located in a region where the orthographic projection of the insulating layer on the driving substrate and the orthographic projection of the planarization layer on the driving substrate overlap with each other, and the plurality of second vents are uniformly arranged; the display substrate further includes a plurality of third filling structures in the same layer and made of the same material as the pixel defining layer; and the plurality of third filling structures are in one-to-one correspondence with the plurality of second vents, and an orthographic projection of each third filling structure on the driving substrate covers an orthographic projection of the corresponding second vent on the driving substrate.

In some embodiments, the planarization layer in the third region includes first climbing regions and flat regions, which are sequentially arranged along the fifth direction; and the orthographic projections of the plurality of second vents on the driving substrate are located within orthographic projections of the flat regions on the driving substrate.

In some embodiments, the planarization layer in the third region includes a first sub-layer, a second sub-layer, and a third sub-layer, which are sequentially stacked in a direction away from the driving substrate; each of the first sub-layer, the second sub-layer, and the third sub-layer includes the first climbing region and the flat region, and the flat region and the first climbing region of each of the first sub-layer, the second sub-layer, and the third sub-layer are sequentially arranged along the fifth direction; and the orthographic projections of the plurality of second vents on the driving substrate are located in a region where orthographic projections of the flat regions of at least two of the first sub-layer, the second sub-layer and the third sub-layer on the driving substrate overlap with each other.

In some embodiments, the display substrate further includes a second conductive pattern in the same layer as the first conductive pattern and between the insulating layer and the corresponding third filling structure; an orthographic projection of the second conductive pattern on the driving substrate at least covers a partial boundary of the corresponding second vent; an orthographic projection of a boundary of the second conductive pattern on the driving substrate is located in the orthographic projection of the insulating layer on the driving substrate; and the orthographic projection of the third filling structure on the driving substrate covers the boundary of the corresponding second vent and the boundary of the corresponding second conductive pattern.

In some embodiments, a portion of the insulating layer located in the display region and a portion of the insulating layer located in the third region are spaced apart from each other in the third region, and the orthographic projection of the pixel defining layer on the driving substrate covers at least a part of a separation boundary of the insulating layer.

In some embodiments, each first climbing region has a slope angle in a range from 15° to 80°.

In some embodiments, an orthographic projection of each first climbing region on the driving substrate has a width in a range of 1µm to 30µm along the second direction.

In a third aspect, an embodiment of the present disclosure further provides a display panel, which includes the display substrate.

In the display substrate provided by the embodiment of the present disclosure, the orthographic projection of the boundary of the insulating layer on the driving substrate is located in the orthographic projection region of the flat region on the driving substrate, or the orthographic projection of the boundary of the insulating layer on the driving substrate does not overlap with the orthographic projection of the planarization layer on the driving substrate at the position or in the region in the display substrate where the orthographic projection of any first climbing region on the driving substrate does not overlap with the orthographic projection of the pixel defining layer on the driving substrate, so that the greater segment gap for layers can be prevented from being formed in the planarization layer under the insulating layer in the process for forming the insulating layer, the inorganic encapsulation layer for encapsulating the light-emitting devices formed on the display substrate can be prevented from cracking at the greater segment gap for layers, the water vapor can be prevented from entering the OLED display panel from the crack position, and therefore, the GDSH and GDSX issues regarding the reliability of the display panel adopting the display substrate can be avoided.

The display panel provided by the embodiment of the present disclosure, by adopting the display substrate in the above embodiments, can solve or avoid the GDSH and GDSX issues regarding the reliability and improve the quality of the display panel.

### BRIEF DESCRIPTION OF DRAWINGS

The accompanying drawings, which are provided for further understanding of embodiments of the present disclosure and constitute a part of this specification, are for explaining the present disclosure together with the embodiments of the present disclosure but are not intended to limit the present disclosure. The above and other features and advantages will become more apparent to one of ordinary skill in the art by describing in detail exemplary embodiments thereof with reference to the drawings. In the drawings:
FIG. 1a is a schematic diagram of a structure of a light-emitting unit in an OLED display panel in the related art.
FIG. 1b is a cross-sectional view of a part of a display region of an OLED display panel in one embodiment in the related art.
FIG. 1c is a schematic top view of a structure of an OLED display panel in the related art.
FIG. 1d is a schematic top view of a hole peripheral region of an OLED display panel in the related art.
FIG. 1e is a schematic top view of a cut-off position of an insulating layer in a hole peripheral region of an OLED display panel in the related art.
FIG. 1f is a schematic diagram of a focused ion beam along a section line AA' shown in FIG. 1e.
FIG. 2a is a schematic top view of a display substrate according to an embodiment of the present disclosure.
FIG. 2b is a schematic top view of a part of a structure of a hole peripheral region in a display substrate according to an embodiment of the present disclosure.
FIG. 2c is a schematic cross-sectional view of a structure along a section line BB' in FIG. 2b.
FIG. 2d is a schematic top view of partition grooves arranged in an insulating layer in a hole peripheral region of a display substrate according to an embodiment of the present disclosure.
FIG. 2e is an enlarged schematic top view of partition grooves and partition portions around a periphery of a hole region according to an embodiment of the present disclosure.
FIG. 2f is a schematic diagram illustrating examples of different numbers and shapes of hole regions according to an embodiment of the present disclosure.
FIG. 2g is a schematic top view illustrating a distribution of first isolation pillars, first dams, and second isolation pillars in a display substrate according to an embodiment of the present disclosure.
FIG. 2h is a cross-sectional view of a part of a display region in a display panel of a display substrate according to an embodiment of the present disclosure.
FIG. 2i is a schematic top view of a part of a structure of a flat region of a planarization layer in a hole peripheral region of a display substrate according to an embodiment of the present disclosure.
FIG. 3a is a schematic top view of a part of a structure of an overlapping region between an insulating layer and a planarization layer in a hole peripheral region of a display substrate according to an embodiment of the present disclosure.
FIG. 3b is a schematic cross-sectional view of a structure taken along a section line CC' in FIG. 3a.
FIG. 4a is a schematic top view of a structure of a first region of a display substrate according to an embodiment of the present disclosure.
FIG. 4b is a cross-sectional view of a structure taken along a section line DD' in FIG. 4a.
FIG. 5a is a schematic top view of a structure of a second region of a display substrate according to an embodiment of the present disclosure.
FIG. 5b is an enlarged schematic top view of a portion E in FIG. 5a.
FIG. 5c is a cross-sectional view of a structure taken along a section line FF' in FIG. 5b.
FIG. 6a is a schematic top view of a structure of a third region in a display substrate according to an embodiment of the present disclosure.
FIG. 6b is a cross-sectional view of a structure taken along a section line GG' in FIG. 6a.
FIG. 6c is a schematic top view of a second conductive pattern and a second vent in a display substrate according to an embodiment of the present disclosure.

### DETAIL DESCRIPTION OF EMBODIMENTS

In order to enable one of ordinary skill in the art to better understand the technical solutions of the embodiments of the present disclosure, a display substrate and a display panel of the embodiments of the present disclosure will be described in further detail with reference to the accompanying drawings and the detailed description.

The embodiments of the present disclosure will be described more fully hereinafter with reference to the accompanying drawings, but the embodiments shown may be embodied in different forms and should not be construed as limited to the embodiments set forth herein. Rather, these embodiments are provided so that this disclosure will be thorough and complete, and will fully convey the scope of the present disclosure to one ordinary skill in the art.

The disclosed embodiments are not limited to the embodiments shown in the drawings, but include modifications of configurations formed based on a manufacturing process. Thus, areas illustrated in the drawings have schematic properties, and shapes of the areas shown in the drawings illustrate specific shapes of the areas of elements, but are not intended to be limiting.

In the related art, an OLED display panel includes a driving substrate and an organic material layer. The organic material layer is disposed on one side of the driving substrate and includes a plurality of light-emitting units, each of which may include one or more light-emitting devices serially connected to each other. Each light-emitting device may be an organic light-emitting diode, and may include an anode, an organic material layer, and a cathode sequentially stacked in a direction away from the driving substrate. The organic material layer may be driven to emit light by applying an electrical signal to the anode and the cathode, and a specific light-emitting principle of the light-emitting devices is not described in detail herein.

The organic material layers of the light-emitting devices may realize a color display by emitting monochromatic light or white light in cooperation with a color film layer. That is, the light-emitting devices share the same continuous organic material layer, the organic material layer may emit white light or other monochromatic light, the color film layer is provided with a plurality of filtering portions in one-to-one correspondence with the light-emitting units, each filtering portion and the corresponding light-emitting unit may form one sub-pixel, a plurality of sub-pixels form one pixel, and different filtering portions may transmit the light of different colors therethrough, so that the light-emitting colors of different sub-pixels may be different. Each pixel includes a plurality of sub-pixels with different colors. For example, each pixel may include three sub-pixels with light-emitting colors of red, green and blue. Therefore, the color display may be realized by the plurality of pixels.

In the related art, the organic material layer has a continuous whole layer structure, so that leakage is likely to occur between any two adjacent light-emitting units, resulting in color crosstalk. Each light-emitting unit may include a plurality of light-emitting devices connected in series, the light-emitting devices of each light-emitting unit share an anode and a cathode between a plurality of light-emitting sub-layers are arranged, and at least two adjacent light-emitting sub-layers may be connected in series through a charge generation layer. Positive charges (holes) may be transferred between two adjacent light-emitting units through the charge generation layer. For example, when a light-emitting unit corresponding to a red filtering portion in the color film layer emits light, a light-emitting unit corresponding to a green filtering portion in the color film layer also emits light due to the leakage, which results in a decrease in the light-emitting purity of each pixel and the color gamut of the entire display panel.

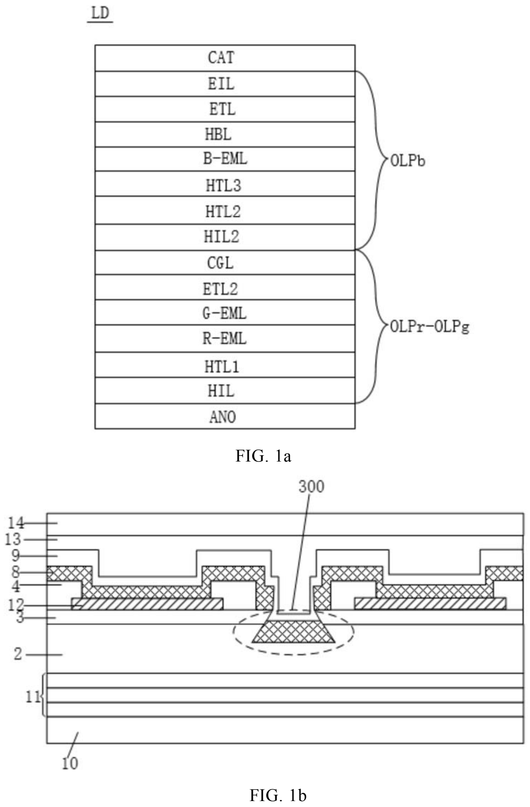

FIG. 1a is a schematic diagram of a structure of a light-emitting unit in an OLED display panel in the related art. In some embodiments, referring to FIG. 1a, each light-emitting unit may include a plurality of light-emitting devices LD connected in series, and an anode ANO, a cathode CAT, and a plurality of light-emitting sub-layers OLP between the anode ANO and the cathode CAT, and the light-emitting devices LD of each light-emitting unit may share the same anode ANO and the same cathode CAT. That is, each light-emitting unit may include only one anode ANO and one cathode CAT.

For example: referring to FIG. 1a, the organic material layer may include the plurality of sub-layers OLP connected in series in a direction away from the driving substrate, and at least one sub-layer OLP is connected in series with an adjacent sub-layer OLP through a charge generation layer CGL. Each sub-layer OLP may emit light when an electrical signal is applied to the anode ANO and the cathode CAT, and different sub-layers OLP may be used to emit light of different colors.

In some embodiments, referring to FIG. 1a, each sub-layer OLP may include a hole injection layer HIL, a hole transport layer HTL, a light-emitting material layer EML, an electron transport layer ETL, and an electron injection layer EIL arranged in the direction away from the driving substrate, and a specific light-emitting principle is not detailed here. The numbers of the hole injection layers HIL, the hole transport layers HTL, the electron transport layers ETL, and the electron injection layers EIL are not particularly limited herein, and the adjacent light-emitting sub-layers OLP may share one or more of the hole injection layer HIL, the hole transport layer HTL, the electron transport layer ETL, and the electron injection layer EIL. In addition, at least two adjacent sub-layers OLP may be provided with a charge generation layer CGL therebetween, so that the sub-layers OLP are connected in series.

In some embodiments, referring to FIG. 1a, the organic material layer may include three sub-layers OLP having different colors, i.e., a first sub-layer OLPr emitting red light, a second sub-layer OLPg emitting green light, and a third sub-layer OLPb emitting blue light, which may emit light at the same time, so that the organic material layer OL emits white light. The first sub-layer OLPr and the second sub-layer OLPg share the hole injection layer HIL, the hole transport layer HTL1, the electron transport layer ETL2, and the electron injection layer EIL, and the light-emitting material layer G-EML of the second sub-layer OLPg is disposed on a surface of the light-emitting material layer R-EML of the first sub-layer OLPr away from the driving substrate, so that the first sub-layer OLPr and the second sub-layer OLPg are directly connected in series without through a special charge generation layer. The charge generation layer CGL may be provided on the surface of the second sub-layer OLPg away from the driving substrate. The third sub-layer OLPb shares the electron injection layer EIL with the first sub-layer OLPr and the second sub-layer OLPg, the hole injection layer HIL2 of the third sub-layer OLPb is disposed on a surface of the charge generation layer CGL away from the driving substrate, hole transport layers HTL2 and HTL3 of the third sub-layer OLPb are stacked on a side of the charge generation layer CGL away from the driving substrate, and the third sub-layer OLPb may be connected in series with the second sub-layer OLPg and the first sub-layer OLPr through the charge generation layer CGL. Further, a hole block layer HBL may be disposed between the electron transport layer ETL and the light-emitting material layer B-EML of the third sub-layer OLPb.

The structure of the organic material layer OL is only exemplary in FIG. 1a, and does not limit the layers of the organic material layer OL. The organic material layer OL may include only two sub-layers OLP, or more sub-layers, or only one sub-layer OLP, as long as the color display may be realized in cooperation with the color film layer.

In some embodiments, the light-emitting units share the organic material layer, carriers (for example, the holes) of one light-emitting unit may move to other light-emitting units, in particular, to an adjacent light-emitting unit, through the charge generation layer CGL or other layer, so that the leakage occurs, which affects the light-emitting purity and results in the color crosstalk.

FIG. 1b is a partial cross-sectional view of a display region of an OLED display panel in one embodiment in the related art. In the related art, as shown in FIG. 1b, the OLED display panel may include the driving substrate, a plurality of anodes 12, a pixel defining layer 4, an organic material layer 8, a cathode 9, an encapsulation layer 13, and a polarizer 14. The pixel defining layer 4 and the anodes 12 are disposed on a same side of the driving substrate, the pixel defining layer 4 is provided with a plurality of first openings therein, and each anode 12 is exposed at the corresponding first opening. The driving substrate includes a substrate 10, and a pixel circuit 11, a planarization layer 2 and an insulating layer 3 sequentially arranged on one side of the substrate 10. Each anode 12 is located on a side of the insulating layer 3 away from the substrate 10, the pixel defining layer 4 is located on a side of the anode 12 away from the substrate 10, the organic material layer 8 is located on a side of the pixel defining layer 4 away from the substrate 10, and covers the whole display region, the cathode 9 is located on a side of the organic material layer 8 away from the substrate 10, and covers the organic material layer 8, any anode 12 in the OLED display panel, the organic material layer 8 and the cathode 9 corresponding to the anode 12 may form one light-emitting unit, and the pixel defining layer 4 may separate the light-emitting units from each other to define the range of the light-emitting units. The encapsulation layer 13 is located on a side of the cathode 9 away from the substrate 10 for encapsulating the light-emitting units. The polarizer 14 is located on a side of the encapsulation layer 13 away from the substrate 10 for reducing the reflection of ambient light by the OLED display panel.

As shown in FIG. 1b, the pixel defining layer 4 is further provided with second openings, which is located in a region outside the region where the corresponding anode 12 is located, a groove 300 is formed in the region of the insulating layer 3 and the planarization layer 2 where the corresponding second opening is located, and the groove 300 in a cross section perpendicular to the substrate has a trapezoidal shape. At least one portion of the organic material layer 8 recessed in the second opening and the trapezoidal groove 300 with a narrow top and a wide bottom corresponding to each other is disconnected from other portions of the organic material layer 8, thereby preventing the carriers from moving between the light-emitting units, and avoiding the color crosstalk due to the leakage.

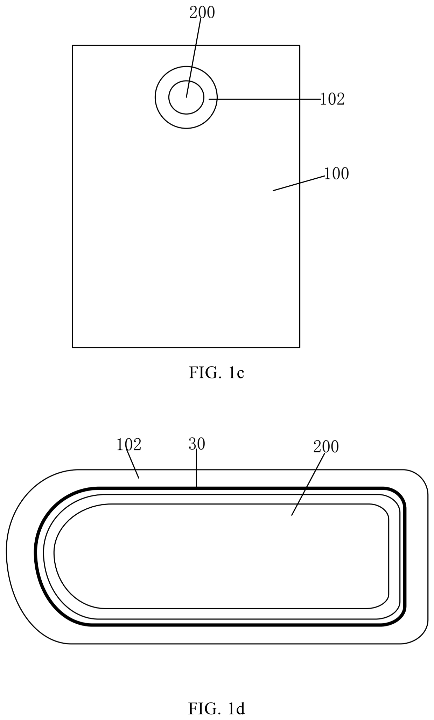

FIG. 1c is a schematic top view of a structure of an OLED display panel in the related art. FIG. 1d is a schematic top view of a hole peripheral region of an OLED display panel in the related art. In some embodiments, as shown in FIGS. 1c and 1d, a through hole 200 is provided in the display region 100 of the OLED display panel and extends through a thickness direction of the OLED display panel, a camera is mounted in the through hole 200, a part of the insulating layer 3 is also located in a hole peripheral region 102 of the through hole 200, and a partition groove 30 is provided in the insulating layer 3 in the hole peripheral region 102, and is used for further separating the organic material layer and the cathode layer which extend from the display region 100 to the hole peripheral region 102. In the OLED display panel where the partition groove 30 is provided in the insulating layer 3 in the hole peripheral region 102, an occurrence rate of a display black spot phenomenon (GDSH) is 10% at a border between the display region 100 and the hole peripheral region 102 under the reliability test condition. In order to further reduce the occurrence rate of the GDSH, it is necessary to further improve a power-off effect of the organic material layer and the cathode in the hole peripheral region 102, and further optimize a cut-off position of the insulating layer 3 in the hole peripheral region 102.

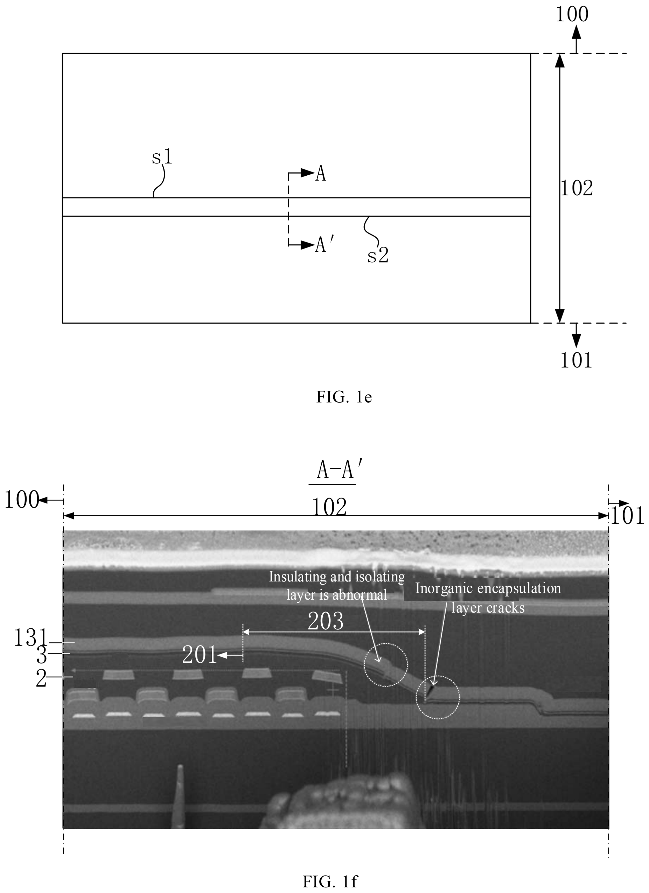

FIG. 1e is a schematic top view of a cut-off position of an insulating layer in a hole peripheral region of an OLED display panel in the related art. FIG. 1f is a schematic diagram of a focused ion beam along a section line AA' shown in FIG. 1e. In some embodiments, as shown in FIGS. 1e and 1f, the planarization layer 2 extends from the display region 100 to the hole peripheral region 102, and forms a climbing region 203 at the cut-off position in the hole peripheral region 102. The cut-off position s1 of the insulating layer 3 on a side close to a hole region 101 in the hole peripheral region 102 is located at the climbing region 203 of the planarization layer 2. For example, the cut-off position s1 of the insulating layer 3 on the side close to the hole region 101 is far away from a cut-off position s2 of the planarization layer 2 on a side close to the hole region 101 by 2.55µm, the cut-off position s1 of the insulating layer 3 on the side close to the hole region 101 may be located on an upper portion of the climbing region 203 of the planarization layer 2 close to a flat region 201 of the planarization layer 2 under the influence of fluctuation of the actual stacking process for layers. A recess having a depth of about 2000 angstroms is formed through dry etching in the planarization layer 2 under the insulating layer 3 at the cut-off position s1 of the insulating layer 3 in the process of forming the insulating layer 3. In the cut-off position s1 of the insulating layer 3, in order to avoid the GDSH failure due to the invasion of water vapor along the organic layer, a portion of the pixel defining layer is removed at that position, so that at the cut-off position s1 of the insulating layer 3, the pixel defining layer cannot fill the recess in the planarization layer 2 and a segment gap of the insulating layer 3 at the cut-off position s1, which may cause an inorganic encapsulation layer 131 on a side of the insulating layer 3 away from the planarization layer 2 to significantly crack, so that the water vapor enters the OLED display panel from the crack position of the inorganic encapsulation layer 131, causing more serious GDSH failure, and the insulating layer 3 has significant abnormality on the climbing region 203 of the entire planarization layer 2, which is suspected to be caused by a difference of a film stress at this position due to the crack of the inorganic encapsulation layer 131. Therefore, the design of the cut-off position of the insulating layer in the hole peripheral region is to be improved.

In some embodiments, the insulating layer is further applied to a border region (e.g., a border region on a binding side) to protect an exposed metal conductive structure, but the cut-off position of the insulating layer in the border region is located in the climbing region of the planarization layer or at the cut-off position of the metal conductive structure (e.g., the conductive structure in the border region in the same layer as the anode in the display region, wherein the conductive structure is in direct contact with the insulating layer, or other inorganic insulating layers may be sandwiched between the conductive structure and the insulating layer), so that a greater segment gap for layers are formed, resulting in the crack of an inorganic encapsulation layer (CVD) above a position of the segment gap for layers. Especially when the cut-off position of the insulating layer is located in the climbing regions of three stacked planarization layers, the risk of the crack of the inorganic encapsulation layer is more uncontrollable, and the water vapor enters the OLED display panel from the crack position of the inorganic encapsulation layer, which causes GDSH and GDSX issues regarding the reliability of the OLED display panel (that is, the poor encapsulation for the border region causes the water vapor to enter the OLED display panel, which causes the poor display of the display region).

In order to solve the problems of the GDSH and GDSX issues regarding the reliability of the OLED display panel due to the design of the cut-off position of the insulating layer in the related art, in a first aspect, an embodiment of the present disclosure provides a display substrate, including a driving substrate, a planarization layer, an insulating layer, and a pixel defining layer, where the planarization layer, the insulating layer, and the pixel defining layer are sequentially stacked on one side of the driving substrate, the planarization layer includes a plurality of first climbing regions where a size of the planarization layer in a first direction gradually increases from 0 to a maximum value, and the first direction is a direction of the planarization layer away from the driving substrate (that is, a direction from the driving substrate to the planarization layer); an orthographic projection of the plurality of first climbing regions on the driving substrate and an orthographic projection of the pixel defining layer on the driving substrate do not at least partially overlap with each other; the insulating layer includes at least one boundary, and an orthographic projection of at least part of the boundary of the insulating layer on the driving substrate is located outside an orthographic projection of the plurality of first climbing regions on the driving substrate.

In some embodiments, the display substrate includes a display region where a plurality of anodes are disposed between the insulating layer and the pixel defining layer. The pixel defining layer includes a plurality of openings therein, the plurality of anodes are in one-to-one correspondence with the plurality of openings, and at least a part of each anode is exposed at the corresponding opening. An organic material layer and a cathode are sequentially formed on a side of the pixel defining layer away from the driving substrate, the organic material layer covers the whole display region, and the cathode covers the organic material layer. Any anode in the display substrate, the organic material layer and the cathode corresponding to the anode may form one light-emitting device, and the pixel defining layer may separate the light-emitting devices from each other to define the range of the light-emitting devices. An encapsulation layer is located on a side of the cathode away from the driving substrate and used for encapsulating the light-emitting devices. The encapsulation layer is formed by the inorganic encapsulation layer, an organic encapsulation layer and the inorganic encapsulation layer which are sequentially stacked. The organic material layer may be made of an organic electroluminescent material.

The orthographic projection of the plurality of first climbing regions on the driving substrate and the orthographic projection of the pixel defining layer on the driving substrate do not overlap with each other, so that the boundary of the insulating layer is located on the first climbing regions, which results in forming a greater segment gap for layers in the first climbing regions, and a segment gap at the boundary of the insulating layer at the position is further included. If the pixel defining layer is not disposed over the greater segment gap, the segment gap cannot be reduced or filled by the pixel defining layer, which more easily causes the inorganic encapsulation layer for encapsulating the light-emitting devices formed on the display substrate to crack.

In this embodiment, the orthographic projection of the boundary of the insulating layer on the driving substrate is located outside the orthographic projection of the first climbing regions on the driving substrate at the position or in the region in the display substrate where the orthographic projection of any first climbing region on the driving substrate does not overlap with the orthographic projection of the pixel defining layer on the driving substrate, so that the greater segment gap for layers can be prevented from being formed in the planarization layer under the insulating layer in the process for forming the insulating layer, the inorganic encapsulation layer for encapsulating the light-emitting devices formed on the display substrate can be prevented from cracking at the greater segment gap for layers, the water vapor can be prevented from entering the OLED display panel from the crack position, and therefore, the GDSH and GDSX issues regarding the reliability of the display panel adopting the display substrate can be avoided.

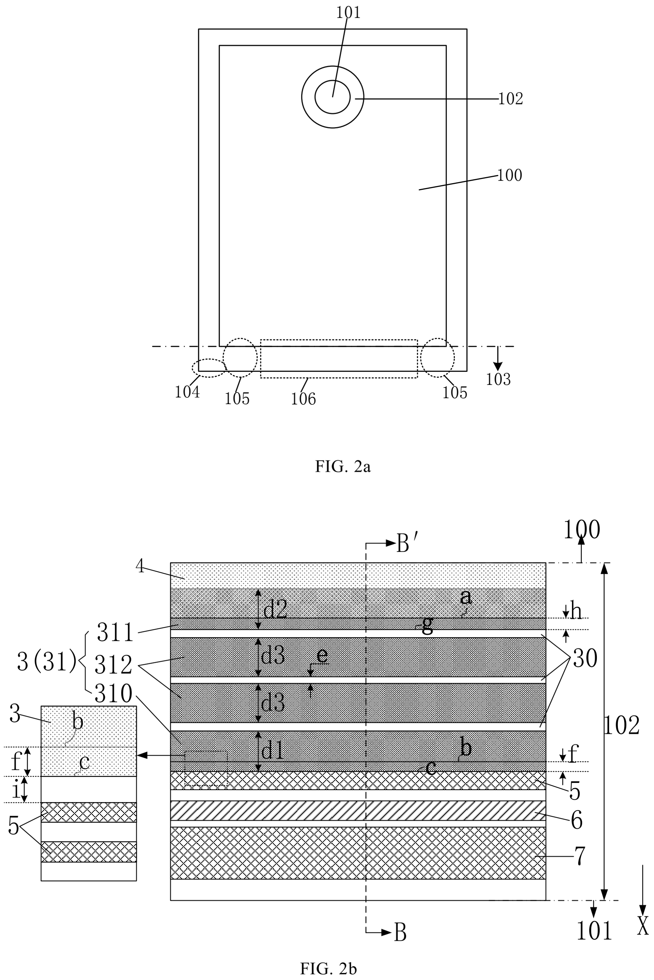

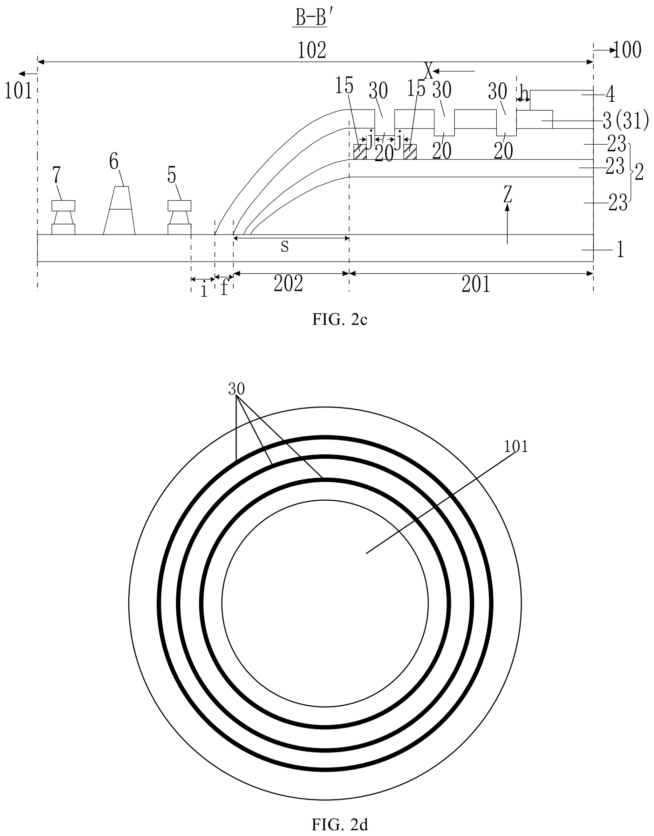

The embodiment of the present disclosure further provides a display substrate. FIG. 2a is a schematic top view of a display substrate according to an embodiment of the present disclosure. FIG. 2b is a schematic top view of a part of a structure of a hole peripheral region in a display substrate according to an embodiment of the present disclosure. FIG. 2c is a schematic cross-sectional view of a structure along a section line BB' in FIG. 2b. Referring to FIGS. 2a, 2b and 2c, the display substrate includes a driving substrate 1, a planarization layer 2, an insulating layer 3, and a pixel defining layer 4, where the planarization layer 2, the insulating layer 3, and the pixel defining layer 4 are sequentially stacked on one side of the driving substrate 1, the planarization layer 2 includes a plurality of flat regions 201 and a plurality of first climbing regions 202, the flat regions 201 abut on the plurality of first climbing regions 202, respectively, an orthographic projection of the plurality of first climbing regions 202 on the driving substrate 1 and an orthographic projection of the pixel defining layer 4 on the driving substrate 1 do not at least partially overlap with each other, a size of the planarization layer 2 in a first direction Z gradually increases from 0 to a maximum value in the plurality of first climbing regions 202, a size of the planarization layer 2 at any position in the first direction Z is approximately the maximum value in the flat regions 201, the first direction is a direction of the planarization layer 2 away from the driving substrate 1 (that is, a direction from the driving substrate 1 to the planarization layer 2), the insulating layer 3 includes at least one boundary, and an orthographic projection of at least part of the boundary of the insulating layer 3 on the driving substrate 1 is located in orthographic projections of the flat regions 201 on the driving substrate 1, or the orthographic projection of at least part of the boundary of the insulating layer 3 on the driving substrate 1 and an orthographic projection of the planarization layer 2 on the driving substrate 1 do not overlap with each other.

The first climbing region 202 refers only to a region formed at a boundary of the planarization layer 2, where the size of the planarization layer in the first direction Z gradually increases from 0 to the maximum value. A portion of the planarization layer 2 is raised by some layers in the driving substrate 1, and a climbing region formed by a portion of the planarization layer 2 not raised by some layers in the driving substrate 1 is not the first climbing region in the present disclosure.

In some embodiments, each first climbing region 202 has a slope angle αin a range from 15° to 80°. In some embodiments, when the planarization layer 2 has a structural feature in which the size of the planarization layer 2 in the first direction Z gradually increases from 0 to the maximum value at the boundary of the planarization layer 2, at this time, if the slope angle formed at the boundary of the planarization layer 2 is less than 15°, the climbing region formed at the boundary of the planarization layer 2 is not the first climbing region in the present disclosure, and the orthographic projection of at least a part of the boundary of the insulating layer 2 on the driving substrate 1 and the orthographic projection of the climbing region at the boundary of the planarization layer 2 on the driving substrate 1 may overlap with each other.

In this embodiment, the orthographic projection of the boundary of the insulating layer 3 on the driving substrate 1 is located inside the orthographic projections of the flat regions 201 on the driving substrate 1, or does not overlap with the orthographic projection of the planarization layer 2 on the driving substrate 1 at the position or in the region in the display substrate where the orthographic projection of any first climbing region 202 on the driving substrate 1 does not overlap with the orthographic projection of the pixel defining layer 4 on the driving substrate 1, so that the greater segment gap for layers can be prevented from being formed in the planarization layer under the insulating layer in the process for forming the insulating layer 3, the inorganic encapsulation layer for encapsulating the light-emitting devices formed on the display substrate can be prevented from cracking at the greater segment gap for layers, the water vapor can be prevented from entering the OLED display panel from the crack position, and therefore, the GDSH and GDSX issues regarding the reliability of the display panel adopting the display substrate can be avoided.

In some embodiments, referring to FIGS. 2a, 2b and 2c, the display substrate includes a display region 100, a hole region 101 and a hole peripheral region 102, the hole peripheral region 102 at least partially surrounds the hole region 101, the display region 100 at least partially surrounds the hole peripheral region 102; the planarization layer 2 and the pixel defining layer 4 respectively extend from the display region 100 to the hole peripheral region 102, and the insulating layer 3 is located in the display region 100 and the hole peripheral region 102; cut-off boundaries a, b, c of the pixel defining layer 4, the planarization layer 2, and the insulating layer 3 are sequentially arranged along a second direction X in the hole peripheral region 102; the cut-off boundaries a, b, and c of the pixel defining layer 4, the planarization layer 2, and the insulating layer 3 are boundaries on a side of the pixel defining layer 4, the planarization layer 2, and the insulating layer 3 close to the hole region 101 in the hole peripheral region 102; and the second direction X is a direction of the hole peripheral region 102 away from the display region 100 and close to the hole region 101 (that is, a direction from the display region 100 to the hole region 101).

The pixel defining layer 4, the planarization layer 2 and the insulating layer 3 are laid (disposed) in the display region 100 and the hole peripheral region 102 in a large area. The cut-off boundary a of the pixel defining layer 4, the cut-off boundary b of the planarization layer 2 and the cut-off boundary c of the insulating layer 3 in the hole peripheral region 102 refer to boundaries of the pixel defining layer 4, the planarization layer 2 and the insulating layer 3 disposed in the hole peripheral region 102 in the large area extending to a side close to the hole region 101. In some embodiments, the cut-off boundary a of the pixel defining layer 4 and the cut-off boundary b of the planarization layer 2 refer to boundaries of portions of the pixel defining layer 4 and the planarization layer 2 extending from the display region 100 to the hole peripheral region 102, and the cut-off boundary c of the insulating layer 3 refers to a boundary of the insulating layer 3 on a side of a pattern of the hole peripheral region 102 close to the hole region 01. The cut-off boundaries a, b, c of the pixel defining layer 4, the planarization layer 2 and the insulating layer 3 do not mean that the pixel defining layer 4, the planarization layer 2 and the insulating layer 3 only extend to these positions where these boundaries are located and do not include other portions at positions other than these positions, but mean that patterns of the pixel defining layer 4, the planarization layer 2 and the insulating layer 3 are broken at these cut-off boundaries.

In this embodiment, referring to FIG. 2b and FIG. 2c, an orthographic projection of the insulating layer 3 on the driving substrate 1 covers the cut-off boundary b of the planarization layer 2, that is, an orthographic projection of the cut-off boundary c of the insulating layer 3 on the driving substrate 1 and the orthographic projection of the planarization layer 2 on the driving substrate 1 do not overlap with each other, so that the greater segment gap for layers can be prevented from being formed in the planarization layer 2 under the insulating layer 3 in the process for forming the insulating layer 3, the inorganic encapsulation layer for encapsulating the light-emitting devices formed on the display substrate can be prevented from cracking at the greater segment gap for layers, the water vapor can be prevented from entering the OLED display panel from the crack position, and therefore, the GDSH and GDSX issues regarding the reliability of the display panel adopting the display substrate can be avoided.

FIG. 2d is a schematic top view of partition grooves disposed in an insulating layer in a hole peripheral region in a display substrate according to an embodiment of the present disclosure. In some embodiments, referring to FIGS. 2b, 2c, and 2d, a plurality of partition grooves 30 are formed in the insulating layer 3 in the hole peripheral region 102, and are sequentially arranged at intervals along the second direction X and configured to partition the insulating layer 3 into a plurality of partition portions 31. The plurality of partition grooves 30 are provided so that the organic material layer and a cathode layer extending from the display region 100 to the hole peripheral region 102 may be further separated, thereby further improving the power-off effect in the hole peripheral region 102 and further reducing the occurrence rate of the GDSH.

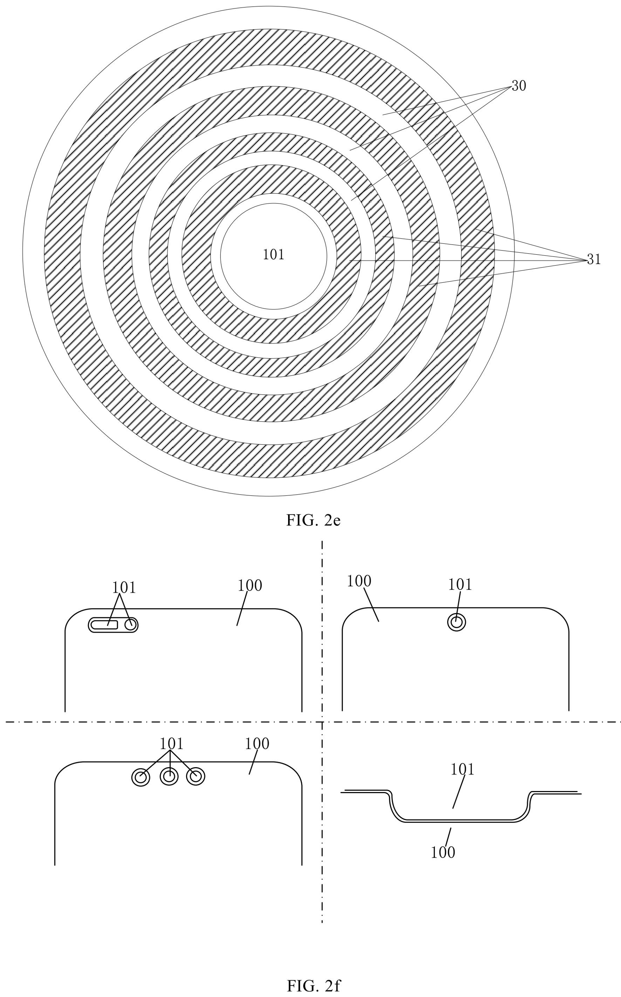

FIG. 2e is an enlarged schematic top view of partition grooves and partition portions around a periphery of a hole region according to an embodiment of the present disclosure. In some embodiments, referring to FIGS. 2d and 2e, an orthographic projection of each of the plurality of partition grooves 30 on the driving substrate 1 is closed and surrounds the hole region 101 and an orthographic projection of each of the plurality of partition portions 31 on the driving substrate 1 is closed and surrounds the hole region 101. That is, the plurality of partition grooves 30 have a ring shape, and the plurality of partition portions 31 also have a ring shape, so that the power-off effect in the hole peripheral region 102 is further improved, and the occurrence rate of the GDSH is further reduced.

FIG. 2f is a schematic diagram of the number of hole regions and a shape of each hole region according to an embodiment of the present disclosure. In some embodiments, referring to FIG. 2f, the display substrate includes at least one hole region 101, each hole region 101 has a shape including a circle, an ellipse, a capsule shape or an inverted trapezoid. For example: the at least one hole region 101 may be a single hole region, two hole regions, or three hole regions. For another example, the shape of each hole region 10 may be a circular hole, a racetrack-shaped hole, or a pill-shaped hole, or the like.

In some embodiments, referring to FIG. 2f, the hole region 101 may be a closed hole, or a non-closed hole. For another example, the hole having a shape of an inverted trapezoid or a bang is a non-closed hole. The non-closed hole means that the hole region 101 is located within the display region 100, a portion of the display region 100 is not present on at least one side of the periphery of the hole region 101. Accordingly, for the non-closed hole region 101, the partition grooves 30 and the partition portions 31 surrounding the hole region 101 are not closed, that is, the partition grooves 30 and the partition portions 31 are only located in the hole peripheral region 102 at the intersection of the hole region 101 and the display region 100.

In some embodiments, referring to FIG. 2c, the planarization layer 2 includes the first climbing regions 202 and the flat regions 201 in the hole peripheral region 102, and the flat regions 201 and the first climbing regions 202 are sequentially arranged along the second direction X. An orthographic projection of the plurality of partition grooves 30 on the driving substrate 1 at least partially overlaps with the orthographic projections of the flat regions 201 on the driving substrate 1.

In some embodiments, a width s of the orthographic projection of each first climbing region 202 on the driving substrate 1 in the second direction X is in a range from 1µm to 30µm.

In some embodiments, an orthographic projection of the plurality of partition grooves 30 on the driving substrate 1 is located within the orthographic projections of the flat regions 201 on the driving substrate 1. With such the arrangement, recesses 20 each having a depth of about 2000 angstroms is formed through dry etching in the flat regions 201 of the planarization layer 2 under the insulating layer 3 at positions corresponding to the partition grooves 30 so that on one hand, the partition grooves 30 and the recesses 20 may further separate the organic material layer and the cathode layer extending from the display region 100 to the hole peripheral region 102, so as to further improve a power-off effect in the hole peripheral region 102, and further reduce the occurrence rate of the GDSH, and on the other hand, the partition grooves 30 are located in the flat regions 201 of the planarization layer 2, so that a greater and irregular segment gap for layers can be prevented from being formed in the flat regions 201 of the planarization layer 2 located under the insulating layer 3 in the process for forming the insulating layer 3, the inorganic encapsulation layer for encapsulating the light-emitting devices formed above the display substrate can be prevented from cracking at the greater and irregular segment gap for layers, the water vapor can be further prevented from entering the OLED display panel from the crack position, and therefore, the GDSH and GDSX issues regarding the reliability of the display panel adopting the display substrate can be avoided.

In some embodiments, the number of the partition grooves 30 is in a range from 2 to 5. Compared with the scheme in the related art that only one partition groove is formed in the insulating layer in the hole peripheral region, the number of the partition grooves 30 is increased in the embodiment of the present disclosure, so that the organic material layer and the cathode layer extending from the display region 100 to the hole peripheral region 102 may be further separated, the power-off effect in the hole peripheral region 102 is further improved, and the occurrence rate of the GDSH is further reduced.

In some embodiments, widths of the plurality of partition portions 31 in the second direction X are equal to each other.

In some embodiments, referring to FIG. 2b, the widths of the plurality of partition portions 31 in the second direction X are not equal to each other.

In some embodiments, referring to FIG. 2b, a partition portion 31 closest to the hole region 101 is a first partition portion 310, a partition portion 31 closest to the display region 100 is a second partition portion 311, and a partition portion 31 located between the first partition portion 310 and the second partition portion 311 is an intermediate partition portion 312. At least one intermediate partition portion 312 is included, widths d1, d2 of the first partition portion 310 and the second partition portion 311 in the second direction X are greater than a width d3 of the intermediate partition portion 312 in the second direction X, respectively, and the width d2 of the second partition portion 311 in the second direction X is greater than the width d1 of the first partition portion 310 in the second direction X.

In some embodiments, referring to FIG. 2b, the width d1 of the first partition portion 310 in the second direction X is in a range from 81µm to 83µm, the width d2 of the second partition portion 311 in the second direction X is in a range of 85µm to 89µm, and the width d3 of the intermediate partition portion 312 in the second direction X is in a range from 75µm to 80µm.

In some embodiments, the width d1 of the first partition portion 310 in the second direction X is 81µm, the width d2 of the second partition portion 311 in the second direction X is 88µm, and the width d3 of the intermediate partition portion 312 in the second direction X is 80µm.

In some embodiments, a width of any partition portion 31 in the second direction X is not less than 10µm.

In some embodiments, the minimum value and the maximum value of the width of each partition portion 31 in the second direction X mainly depend on the cut-off boundary a of the pixel defining layer 4, the cut-off boundary b of the planarization layer 2, and the cut-off boundary c of the insulating layer 3, and a width of the hole peripheral region 102, and are determined according to the actual process capability and the actual product design in consideration of a peeling risk of the surfaces of the insulating layer 3 and the planarization layer 2 in contact with each other.

In some embodiments, referring to FIG. 2b, a width of each partition groove 30 in the second direction X is less than the width of each partition portion 31 in the second direction X. In this way, it is more advantageous to further separate the organic material layer and the cathode layer extending from the display region 100 to the hole peripheral region 102, and further enhance the power-off effect in the hole peripheral region 102.

In some embodiments, referring to FIG. 2b, the width e of each partition groove 30 in the second direction X is in a range from 3µm to 10µm. For example: the width e of each partition groove 30 in the second direction X may have any value such as 10µm, 9µm, 8µm, 7µm, 6µm, 5µm, 4µm, or 3µm.

In some embodiments, referring to FIG. 2b and FIG. 2c, a boundary of the first partition portion 310 close to the hole region 101 is the cut-off boundary c of the insulating layer 3, and a distance f between the orthographic projection of the cut-off boundary c of the insulating layer 3 on the driving substrate 1 and an orthographic projection of the cut-off boundary b of the planarization layer 2 on the driving substrate 1 is greater than or equal to 3.5µm and less than the width d1 of the first partition portion 310 in the second direction X. In this way, it can be ensured that the orthographic projection of the cut-off boundary c of the insulating layer 3 on the driving substrate 1 does not overlap with the orthographic projection of the planarization layer 2 on the driving substrate 1, that is, the insulating layer 3 covers start positions of the first climbing regions 202 of the planarization layer 2, so that the greater segment gap for layers can be prevented from being formed in the first climbing regions 202 of the planarization layer 2 under the insulating layer 3 in the process for forming the insulating layer 3, the inorganic encapsulation layer for encapsulating the light-emitting devices formed on the display substrate can be prevented from cracking at the greater segment gap for layers, the water vapor can be prevented from entering the OLED display panel from the crack position, and therefore, the GDSH and GDSX issues regarding the reliability of the display panel adopting the display substrate can be avoided.

In some embodiments, referring to FIGS. 2b and 2c, a portion of the insulating layer 3 located in the display region 100 and a portion of the insulating layer 3 located in the hole peripheral region 102 are separated from each other in the hole peripheral region 102, and the orthographic projection of the pixel defining layer 4 on the driving substrate 1 covers at least a part of a separation boundary of the insulating layer 3. Here, the separation boundary of the insulating layer 3 is a boundary formed by separating a pattern of the portion of the insulating layer 3 located in the display region 100 and a pattern of the portion of the insulating layer 3 located in the hole peripheral region 102 from each other in the hole peripheral region 102. The pixel defining layer 4 extends from the display region 100 to the hole peripheral region 102, the planarization layer 2 is laid under a broken position of the insulating layer 3. With such the arrangement, the pixel defining layer 4 may fill the greater segment gap for layers (including a segment gap for the thickness of the insulating layer 3 and a segment gap for the recess formed in the planarization layer 2 under the insulating layer 3) formed at the broken position of the insulating layer 3, so that the inorganic encapsulation layer can be prevented from cracking due to the greater segment gap for layers at the broken position of the insulating layer 3, the water vapor can be further prevented from entering the OLED display panel from the crack position, and therefore, the GDSH and GDSX issues regarding the reliability of the display panel adopting the display substrate can be avoided.

In some embodiments, referring to FIGS. 2b and 2c, a boundary g of the second partition portion 311 close to the hole region 101 is located on a side of the cut-off boundary a of the pixel defining layer 4 close to the hole region 101, and a distance h between an orthographic projection of the boundary g of the second partition portion 311 close to the hole region 101 on the driving substrate 1 and an orthographic projection of the cut-off boundary a of the pixel defining layer 4 on the driving substrate 1 is greater than or equal to 3µm and less than the width d2 of the second partition portion 311 in the second direction X. With such the arrangement, it can be ensured that the pixel defining layer 4 completely covers a broken boundary of the insulating layer 3 at the broken position in the hole peripheral region 102, so as to sufficiently fill the greater segment gap for layers formed at the broken position of the insulating layer 3, and further prevent the inorganic encapsulation layer from cracking due to the greater segment gap for layers at the broken position of the insulating layer 3.

In some embodiments, referring to FIGS. 2b and 2c, the distance h between the orthographic projection of the boundary g of the second partition portion 311 close to the hole region 101 on the driving substrate 1 and the orthographic projection of the cut-off boundary a of the pixel defining layer 4 on the driving substrate 1 is greater than or equal to 5µm.

In some embodiments, referring to FIGS. 2b and 2c, the driving substrate 1 includes a substrate, a plurality of conductive layers and a plurality of inorganic insulating layers, the plurality of conductive layers and the plurality of inorganic insulating layers are sequentially and alternately stacked on a side of the substrate close to the planarization layer 2, the substrate extends from the display region 100 to the hole peripheral region 102, the plurality of conductive layers are located in the display region 100, at least a part of the conductive layers are located in the hole peripheral region 102, and the plurality of inorganic insulating layers extend from the display region 100 to the hole peripheral region 102. The display substrate further includes a plurality of first isolation pillars 5, a first dam 6 and a plurality of second isolation pillars 7, which are located in the hole peripheral region 102 and are sequentially arranged at intervals along the second direction X. The plurality of first isolation pillars 5 and the plurality of second isolation pillars 7 respectively include at least one conductive layer, the first dam 6 includes a first sub-layer in the same layer and made of the same material as the planarization layer 2 and a second sub-layer in the same layer and made of the same material as the pixel defining layer 4, the first sub-layer and the second sub-layer are sequentially stacked, the plurality of first isolation pillars 5, the first dam 6 and the plurality of second isolation pillars 7 are located on a side of the cut-off boundary c of the insulating layer 3 close to the hole region 101, and orthographic projections of the plurality of first isolation pillars 5, the first dam 6 and the plurality of second isolation pillars 7 on the substrate do not overlap with an orthographic projection of the insulating layer 3 on the substrate.

The plurality of first isolation pillars 5 and the plurality of second isolation pillars 7 are configured to separate the organic material layer and the cathode layer extending from the display region 100 to the hole peripheral region 102 from each other. The plurality of first isolation pillars 5 and the plurality of second isolation pillars 7 are conductive structures formed through a single patterning process together with at least one conductive layer in the driving substrate 1. For example, the plurality of first isolation pillars 5 and the plurality of second isolation pillars 7 are conductive structures formed through a single patterning process together with the anodes in the driving substrate 1, that is, the plurality of first isolation pillars 5 and the plurality of second isolation pillars 7 are sandwiched isolation structures formed by sequentially stacking titanium/aluminum/titanium layers. In some embodiments, the plurality of first isolation pillars 5 and the plurality of second isolation pillars 7 may alternatively be conductive structures formed through a single patterning process together with conductive layers in the driving substrate 1, respectively. For example, the plurality of first isolation pillars 5 and the plurality of second isolation pillars 7 are formed by sequentially stacking a conductive layer in the same layer as the anodes in the driving substrate 1, a conductive layer in the same layer as a first gate electrode in the driving substrate 1, and a conductive layer in the same layer as a second gate electrode in the driving substrate 1, and the inorganic insulating layer for separation and insulation between any two adjacent conductive layers of the first gate electrode, the second gate electrode, and the anodes may be reserved.

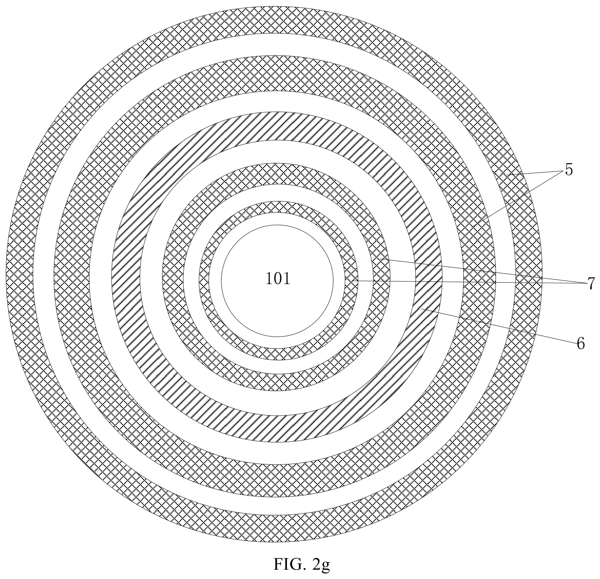

FIG. 2g is a schematic top view illustrating a distribution of first isolation pillars, first dams, and second isolation pillars in a display substrate according to an embodiment of the present disclosure. In some embodiments, referring to FIG. 2g, for example, the hole region 101 is circular, orthographic projections of the first isolation pillars 5 on the substrate are all ring-shaped, orthographic projections of the second isolation pillars 7 on the substrate are all ring-shaped, the orthographic projections of the second isolation pillars 7 on the substrate sequentially surround the hole region 101, the orthographic projections of the first isolation pillars 5 on the substrate sequentially surround the second isolation pillars 7, and the second isolation pillars 7 and the first isolation pillars 5 form a group of concentric rings with a same circle center as that of the hole region 101.

In some embodiments, referring to FIG. 2g, an orthographic projection of the first dam 6 on the substrate is ring-shaped, and surrounds the second isolation pillars 7. Referring to FIG. 2c, a layer of the first dam 6 in the same layer and made of the same material as the pixel defining layer 4 covers an organic layer of the first dam 6 in the same layer and made of the same material as the planarization layer 2. The pixel defining layer 4 and the planarization layer 2 are made of organic insulating materials, such as organic resin materials. The first dam 6 is formed by stacking layers of the organic insulating materials, so that the first dam 6 may be made to be higher or thicker, thereby forming a barrier for a material of the organic encapsulation layer of the encapsulation layer, and preventing the material of the organic encapsulation layer from overflowing to a side of the first dam 6 away from the display region 100 during encapsulation, that is, the organic encapsulation layer of the encapsulation layer extends from the display region 100 to cover a region on a side of the first dam 6 close to the display region 100, and the organic encapsulation layer does not extend beyond the first dam 6. The inorganic encapsulation layer of the encapsulation layer extends from the display region 100 to cover the entire hole peripheral region 102.

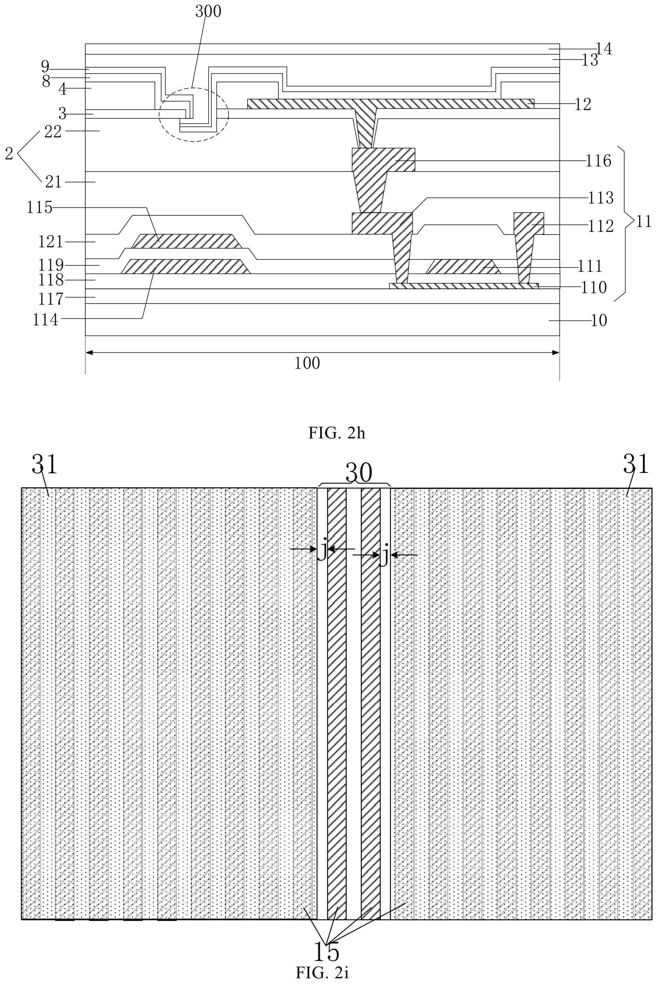

FIG. 2h is a partial cross-sectional view of a display region of a display panel of a display substrate in one embodiment according to an embodiment of the present disclosure. In some embodiments, referring to FIG. 2h, the driving substrate 1 in the display substrate of the embodiment of the present disclosure further includes a pixel circuit 11 and a plurality of anodes 12 disposed on one side of the substrate 10, the pixel circuit 11 is located in the display region 100, and the plurality of anodes 12 are disposed in the same layer. The planarization layer 2, the insulating layer 3, the anodes 12 and the pixel defining layer 4 are sequentially stacked on a side of the pixel circuit 11 away from the substrate 10. The display panel adopting the display substrate further includes an organic material layer 8, a cathode 9, an encapsulation layer 13 and a polarizer 14, which are sequentially stacked on a side of the pixel defining layer 4 away from the driving substrate 1. The pixel circuit 11 includes a transistor and a capacitor, the transistor includes an active layer 110, a gate electrode 111, and a source electrode 112 and a drain electrode 113, and the source electrode 112 and the drain electrode 113 are disposed in the same layer. The capacitor includes a first plate 114 and a second plate 115. The pixel circuit 11 further includes a conductive connection structure 116. The active layer 110, the gate electrode 111, the source electrode 112 and the drain electrode 113 in the same layer, and the conductive connection structure 116 are sequentially arranged in a direction away from the substrate 10. The gate electrode 111 and the first plate 114 are disposed in the same layer. The conductive connection structure 116 is connects the anode 12 and the drain electrode 113 corresponding to each other. The inorganic insulating layer further includes a buffer layer 117, a first gate insulating layer 118, a second gate insulating layer 119, and an intermediate dielectric layer 121. The buffer layer 117 is located between the active layer 110 and the substrate 10. The first gate insulating layer 118 is located between the active layer 110 and the gate electrode 111. The second gate insulating layer 119 is located between the first plate 114 and the second plate 115. The intermediate dielectric layer 121 is located between the second plate 115 and the source electrode 112 and the drain electrode 113 in the same layer. The planarization layer 2 includes a first planarization layer 21 and a second planarization layer 22. The first planarization layer 21 is located between the source electrode 112 and the drain electrode 113 in the same layer and the conductive connection structure 116. The second planarization layer 22 and the insulating layer 3 are located between the anodes 12 and the conductive connection structure 116. The insulating layer 3 is located on a side of the planarization layer 2 away from the substrate 10, and the anodes 12 are located on a side of the insulating layer 3 away from the substrate 10. The pixel defining layer 4 is located on a side of the anodes 12 away from the substrate 10. The organic material layer 8 is located on a side of the pixel defining layer 4 away from the substrate 10. The pixel defining layer 4 is provided with a first opening therein through which the corresponding anode 12 is exposed, and a portion of the organic material layer 8 located in the first opening of the pixel defining layer 4 emits light under an electric field formed between the anodes 12 and the cathode 9. The encapsulation layer 13 is located on a side of the cathode 9 away from the substrate 10. The polarizer 14 is located on a side of the encapsulation layer 13 away from the substrate 10. The anodes 12 are located in the display region 100. The encapsulation layer 13 and the polarizer 14 extend from the display region 100 to cover the hole peripheral region 102. The first isolation pillars 5 and the second isolation pillars 7 are formed through a single patterning process together with at least one conductive layer in the pixel circuit 11.

In some embodiments, the pixel defining layer 4 is further provided with a second opening therein, the second opening is located in a region outside the region corresponding to the corresponding anode 12, a groove 300 is formed in a region of the insulating layer 3 and the planarization layer 2 corresponding to the second opening, and the groove 300 has a narrow top and a wide bottom. At least one portion of the organic material layer 8 recessed in the second opening and the groove 300 with a narrow top and a wide bottom is disconnected from other portions of the organic material layer 8, thereby preventing the carriers from moving between the light-emitting units, and avoiding the color crosstalk due to the leakage.

In some embodiments, referring to FIGS. 2b and 2c, a distance i between the cut-off boundary c of the insulating layer 3 and a boundary of the corresponding first isolation pillar 5 closest to the cut-off boundary c of the insulating layer 3 is greater than or equal to 4µm. With such the arrangement, on one hand, it can be ensured that residues of the insulating layer 3 on side surfaces of edges of the first isolation pillars 5 and the second isolation pillars 7 may be completely etched, so that the first isolation pillars 5 and the second isolation pillars 7 may further separate the organic material layer 8 and the cathode 9 extending to the hole peripheral region 102, the power-off effect in the hole peripheral region 102 is further improved, and the occurrence rate of the GDSH is further reduced. On the other hand, it can be ensured that the insulating layer 3 covers the first climbing regions 202 of the planarization layer 2 with an enough margin.

FIG. 2i is a schematic top view of a part of a structure of a flat region of a planarization layer in a hole peripheral region of a display substrate according to an embodiment of the present disclosure. In some embodiments, referring to FIG. 2c and FIG. 2i, the planarization layer 2 includes a plurality of sub-layers 23, which are sequentially stacked. The display substrate further includes a plurality of first wiring lines 15 located in the hole peripheral region 102 and between two adjacent sub-layers 23, orthographic projections of at least part of the first wiring lines 15 on the driving substrate 1 are located in the flat regions 201, and orthographic projections of the first wiring lines 15 and the partition grooves 30 on the driving substrate 1 do not overlap with each other. With such the arrangement, the first wiring lines 15 can be prevented from being exposed due to the over-etching of the sub-layers 23 at corresponding positions when forming the partition grooves 30, the exposed first wiring lines 15 can be prevented from being corroded by the invasion of the water vapor and the occurrence rate of the GDSH is further reduced.

In some embodiments, referring to FIGS. 2c and 2i, a distance j between orthographic projections of adjacent boundaries of each first wiring line 15 and the corresponding partition groove 30 on the driving substrate 1 is greater than 1µm. With such the arrangement, the first wiring lines 15 can be prevented from being exposed due to the process error when forming the partition grooves 30, the exposed first wiring lines 15 can be prevented from being corroded by the invasion of the water vapor and the occurrence rate of the GDSH is further reduced.

In some embodiments, the first wiring line 15 may be any signal wiring line, such as a data line.

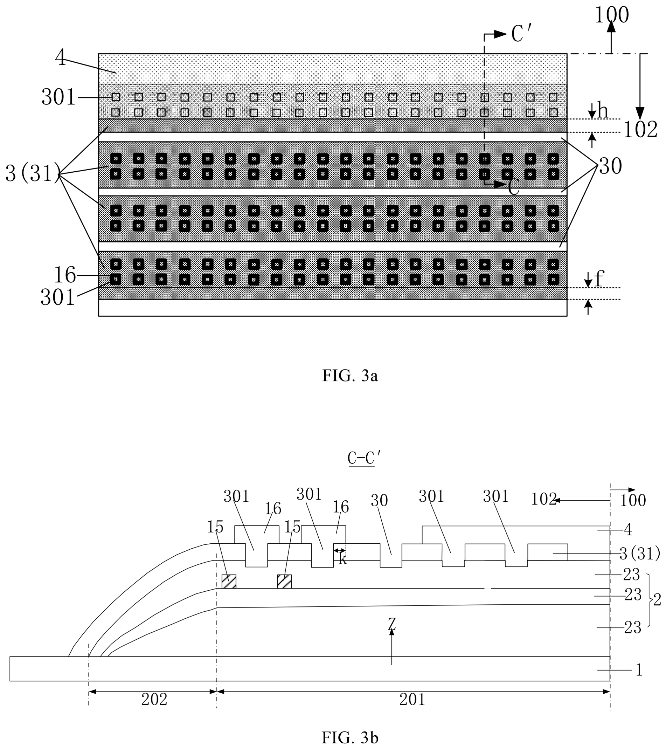

FIG. 3a is a schematic top view of a part of a structure of an overlapping region of an insulating layer and a planarization layer in a hole peripheral region of a display substrate according to an embodiment of the present disclosure. FIG. 3b is a schematic cross-sectional view of a structure taken along a section line CC' in FIG. 3a. In some embodiments, referring to FIGS. 3a and 3b, an orthographic projection of the partition portions 31 on the driving substrate 1 and the orthographic projection of the planarization layer 2 on the driving substrate 1 at least partially overlap with each other, the plurality of partition portions 31 are provided with a plurality of first vents 301 therein, orthographic projections of the plurality of first vents 301 on the driving substrate 1 is located in a region where the orthographic projection of the partition portions 31 on the driving substrate 1 and the orthographic projection of the planarization layer 2 on the driving substrate 1 at least partially overlap with each other, and the plurality of first vents 301 are uniformly arranged. The display substrate further includes a plurality of first filling structures 16 in the same layer and made of the same material as the pixel defining layer 4 and in one-to-one correspondence with the plurality of first vents 301, and an orthographic projection of each first filling structure 16 on the driving substrate 1 covers the corresponding first vent 301.

The planarization layer 2 is made of an organic insulating material, and the organic material of the planarization layer 2 needs to be deflated in the process for forming the planarization layer 2. The insulating layer 3 is made of an inorganic insulating material, such as silicon nitride, silicon oxide or silicon oxynitride. If the insulating layer 3 completely covers the planarization layer 2, the insulating layer 3 may be peeled off due to the deflating of the organic material in the process for forming the planarization layer 2, so that the resulting peeling particles pollute the display region 100, causing the failures. The first vents 301 are formed in the region of the insulating layer 3 overlapping with the planarization layer 2, so that the insulating layer 3 can be prevented from impeding the deflating of the organic material, and therefore, the failures in the display substrate can be avoided. In addition, the first filling structures 16 may fill the segment gap for layers of the insulating layer 3 and the planarization layer 2 at the positions of the first vents 301, so that the inorganic encapsulation layer can be prevented from cracking at the greater segment gap for layers, the water vapor can be prevented from entering the OLED display panel from the crack position, and therefore, the GDSH issue regarding the reliability of the display panel adopting the display substrate can be avoided.

In some embodiments, referring to FIGS. 3a and 3b, a distance k between corresponding boundaries of orthographic projections of a first filling structure 16 and a first vent 301 corresponding to each other on the driving substrate 1 is greater than or equal to 5µm. In this way, the first filling structure 16 may fully cover the corresponding first vent 301, so that it can be further ensured that the first filling structures 16 may fill the segment gap for layers of the insulating layer 3 and the planarization layer 2 at the positions of the first vents 301, the inorganic encapsulation layer can be prevented from cracking at the greater segment gap for layers, the water vapor can be prevented from entering the OLED display panel from the crack position, and therefore, the GDSH issue regarding the reliability of the display panel adopting the display substrate can be avoided.

In some embodiments, a shape of the orthographic projection of each first vent 301 on the driving substrate 1 includes a triangle, a rectangle, a circle, an ellipse, or a polygon, and a shape of the orthographic projection of each first filling structure 16 on the driving substrate 1 includes a triangle, a rectangle, a circle, an ellipse, or a polygon.

In some embodiments, the shape of the orthographic projection of each first vent 301 on the driving substrate 1 and the shape of the orthographic projection of each first filling structure 16 on the driving substrate 1 may be the same as each other or different from each other, as long as the first filling structure 16 completely covers the first vent 301.

In some embodiments, an area of the orthographic projection of each first vent 301 on the driving substrate 1 is in a range from 3 × 3µm² to 10 × 10µm².

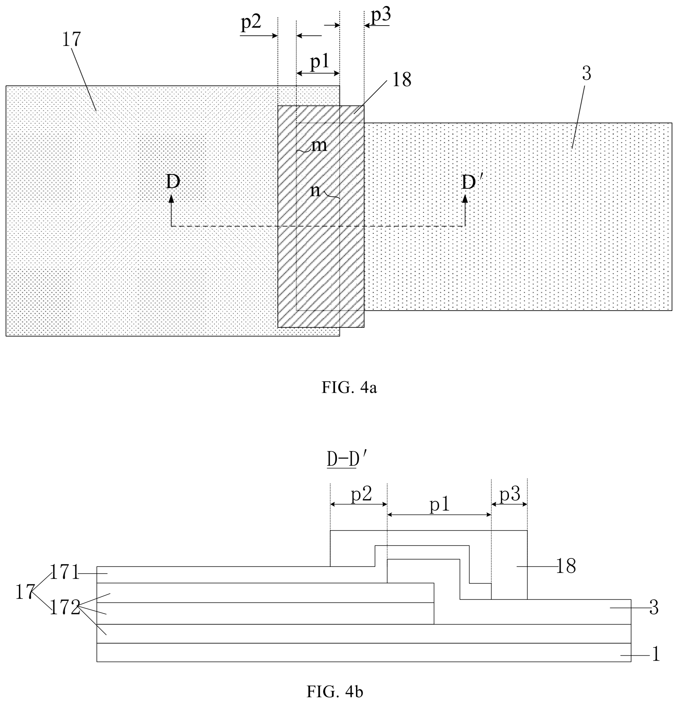

FIG. 4a is a schematic top view of a structure of a first region of a display substrate according to an embodiment of the present disclosure. FIG. 4b is a cross-sectional view of a structure taken along a section line DD' in FIG. 4a. In some embodiments, referring to FIGS. 2a, 4a and 4b, the display substrate further includes a binding region 103 located on one side of the display region 100. The binding region 103 includes a first region 104, at least a part of the conductive layer is located in the first region 104, and the insulating layer 3 is located in the first region 104. The display substrate further includes a power electrode 17 located in the first region 104 and including a first conductive pattern 171 and at least one conductive layer 172, the at least one conductive layer 172 and the first conductive pattern 171 are sequentially stacked in a direction away from the driving substrate 1, the first conductive pattern 171 is located on a side of the insulating layer 3 away from the driving substrate 1 and partially overlaps with the insulating layer 3, an orthographic projection of the first conductive pattern 171 on the driving substrate 1 covers at least a portion of an overlapping boundary m of the insulating layer 3 overlapping with the first conductive pattern 171, and an orthographic projection of an overlapping boundary n of the first conductive pattern 171 overlapping with the insulating layer 3 on the driving substrate 1 is at least partially located in the orthographic projection of the insulating layer 3 on the driving substrate 1.

The first conductive pattern 171 is disposed in the same layer and made of the same material as the anodes in the display region 100. The orthographic projection of the first conductive pattern 171 on the driving substrate 1 covers the overlapping boundary m of the insulating layer 3 overlapping with the first conductive pattern 171, and the orthographic projection of the overlapping boundary n of the first conductive pattern 171 overlapping with the insulating layer 3 on the driving substrate 1 is located in the orthographic projection of the insulating layer 3 on the driving substrate 1, so that the overlapping boundaries of the first conductive pattern 171 and the insulating layer 3 may be staggered with each other. That is, the orthographic projections of the overlapping boundaries of the first conductive pattern 171 and the insulating layer 3 on the driving substrate 1 do not overlap with each other, so that the first conductive pattern 171 is prevented from being undercut due to the segment gap at the boundary of the insulating layer 3 in the coating process at the boundary of the insulating layer 3, causing a resistance of the power electrode 17 to be increased or the conductive performance of the power electrode 17 to be unstable.

In some embodiments, referring to FIGS. 4a and 4b, the region where the orthographic projection of the first conductive pattern 171 on the driving substrate overlaps with the orthographic projection of the insulating layer 3 on the driving substrate has a width p1 greater than or equal to 3µm.

In some embodiments, referring to FIGS. 4a and 4b, the display substrate further includes a second filling structure 18 located in the first region 104 and in the same layer and made of the same material as the pixel defining layer 4, an orthographic projection of the second filling structure 18 on the driving substrate 1 covers a first boundary m of the insulating layer 3 overlapping with the first conductive pattern 171 and a second boundary n of the first conductive pattern 171 overlapping with the insulating layer 3, and a distance p2 between an orthographic projection of the first boundary m on the driving substrate 1 and an orthographic projection of a boundary of the second filling structure 18 located on a side of the first boundary m away from the insulating layer 3 on the driving substrate 1 is greater than or equal to 5µm. A distance p3 between an orthographic projection of the second boundary n on the driving substrate 1 and an orthographic projection of a boundary of the second filling structure 18 located on a side of the second boundary n away from the first conductive pattern 171 on the driving substrate 1 is greater than or equal to 10µm.

The first conductive pattern 171 is easily undercut at the first boundary m of the insulating layer 3 due to the segment gap of the insulating layer 3, and the inorganic encapsulation layer is easily broken at this position due to a recess caused by the undercut, resulting in the risk of the GDSX regarding the reliability for the display substrate. In this embodiment, the second filling structure 18 is provided to cover the first boundary m of the insulating layer 3 and the second boundary n of the first conductive pattern 171, so that the segment gap for layers formed at the first boundary m and the second boundary n may be filled, the segment gap for layers at the first boundary m and the second boundary n is reduced or completely eliminated, and the inorganic encapsulation layer can be prevented from cracking at the segment gap for layers, thereby finally avoiding the risk of the GDSX regarding the reliability for the display substrate.

In some embodiments, the power electrode 17 is a VSS electrode.

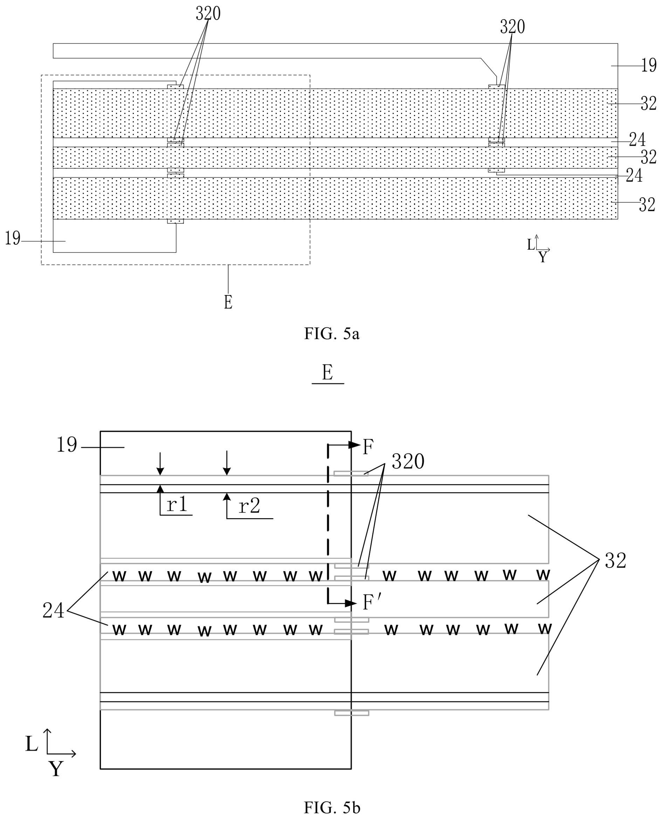

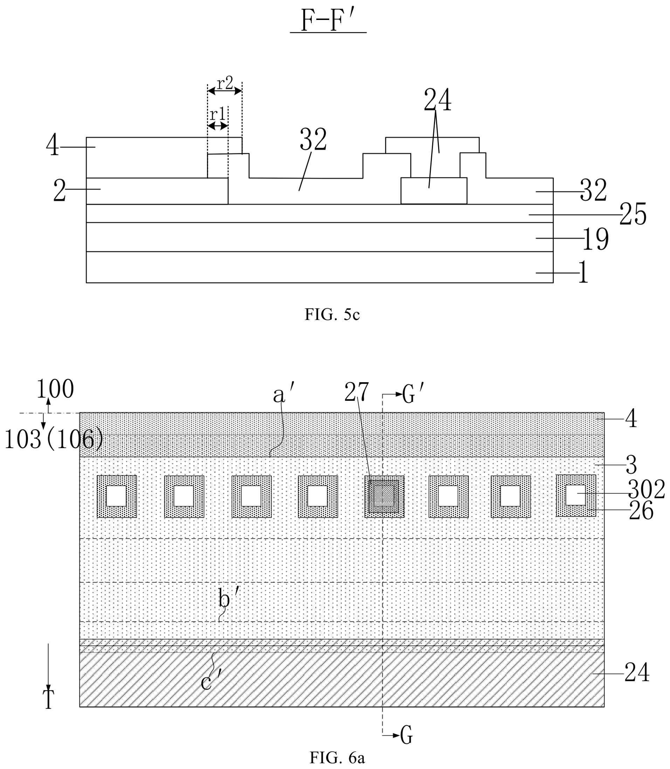

FIG. 5a is a schematic top view of a structure of a second region of a display substrate according to an embodiment of the present disclosure. FIG. 5b is an enlarged schematic top view of a portion E in FIG. 5a. FIG. 5c is a cross-sectional view of a structure taken along a section line FF' in FIG. 5b. In some embodiments, referring to FIG. 2a, FIG. 5a, FIG. 5b and FIG. 5c, the binding region 103 further includes a second region 105, at least a part of the conductive layer is located in the second region 105, and the insulating layer 3 further includes a plurality of partition strips 32 located in the second region 105. The display substrate further includes a power line 19 and a plurality of second dams 24, at least a part of which are located in the second region 105. In the second region 105, the plurality of partition strips 32 and the plurality of second dams 24 extend along a third direction Y, respectively, and are sequentially and alternately arranged along a fourth direction L, the planarization layer 2 and the pixel defining layer 4 further extend to the second region 105, the second dams 24 include third sub-layers in the same layer and made of the same material as the planarization layer 2 and fourth sub-layers in the same layer and made of the same material as the pixel defining layer 4, and the third sub-layers and the fourth sub-layers are sequentially stacked. The power line 19 includes at least one conductive layer, and extending in the fourth direction L. The third direction Y intersects with the fourth direction L. An orthographic projection of the power line 19 on the driving substrate 1 intersects with orthographic projections of the plurality of partition strips 32 and the plurality of second dams 24 on the driving substrate 1. A passivation layer 25 is further arranged between the power line 19 and the partition strips 32 and covers the second region 105, an edge region of each partition strip 32 overlaps with the second dams 24, the planarization layer 2, and the pixel defining layer 4, and a portion of each partition strip 32 other than the edge region is in contact with the passivation layer 25.

The passivation layer 25 is exposed at a periphery of each second dam 24 in the second region 105. The passivation layer 25 under the insulating layer 3 is over-etched due to etching of the insulating layer 3 in the process for forming the insulating layer 3, so that a portion of the insulating layer 3 above the passivation layer 25 at the periphery of each second dam 24 in the second region 105 is reserved, and therefore, the passivation layer 25 is prevented from being over-etched due to etching of the insulating layer 3 in the second region 105, and the conductive structures under the passivation layer 25 are prevented from being exposed. The edge region of each partition strip 32 overlaps with the planarization layer 2, and may cover the boundary of the planarization layer 2. In this case, the boundaries of the partition strips 32 may be located on the first climbing regions 202 or the flat regions 201 of the planarization layer 2. If the edge regions of the partition strips 32 are not covered by the pixel defining layer 4, the partition strips 32 are easily over-etched at the boundaries of the partition strips 32 in the first climbing regions 202 or the flat regions 201 of the planarization layer 2 when forming the partition strips 32, resulting in a recess, so that the inorganic encapsulation layer is cracked, which in turn causes the display substrate to suffer from the GDSX issue. Therefore, the edge regions of the partition strips 32 overlap with the second dams 24, the planarization layer 2, and the pixel defining layer 4, so that the pixel defining layer 4 may cover the boundaries of the partition strips 32, the segment gap for layers formed by the boundaries of the partition strips 32 and the recess in the planarization layer 2 is filled, the inorganic encapsulation layer is prevented from cracking, and the GDSX issue of the display substrate is avoided.

In some embodiments, referring to FIGS. 5b and 5c, in the second region 105, a width r1 of a region where the partition strips 32 and the planarization layer 2 overlap with each other in the fourth direction L is less than a width r2 of a region where the partition strips 32 and the pixel defining layer 4 overlap with each other in the fourth direction L. With such the arrangement, on one hand, the partition strips 32 may cover the boundary of the planarization layer 2, so as to avoid a greater segment gap for layers due to the overlapping of the boundaries of the partition strips 32 with the boundary of the planarization layer 2; on the other hand, the pixel defining layer 4 may sufficiently cover and sufficiently fill the greater segment gap for layers formed by the boundaries of the partition strips 32 and the recess formed by the boundaries in the planarization layer 2, thereby preventing the inorganic encapsulation layer from cracking at the greater segment gap for layers, and avoiding the GDSX issue of the display substrate.

In some embodiments, referring to FIGS. 5b and 5c, the width r2 of the edge region of each partition strip 32 overlapping with the pixel defining layer 4 in the fourth direction L is greater than or equal to 5µm. With such the arrangement, the pixel defining layer 4 may sufficiently cover and sufficiently fill the greater segment gap for layers formed by the boundaries of the partition strips 32 and the recess formed by the boundaries in the planarization layer 2, thereby preventing the inorganic encapsulation layer from cracking at the greater segment gap for layers, and avoiding the GDSX issue of the display substrate.

In some embodiments, referring to FIG. 5c, orthographic projections of the boundaries of the partition strips 32 on the planarization layer 2 are located in the flat regions 201. With such the arrangement, an uncontrollable greater segment gap for layers can be prevented from being formed in the planarization layer 2 under the boundaries of the partition strips 32 in the process for forming the partition strips 32, the inorganic encapsulation layer can be prevented from cracking at the uncontrollable greater segment gap for layers, and the GDSX issue of the display substrate can be avoided.

In some embodiments, referring to FIGS. 5a and 5b, in a region where each partition strip 32 overlaps with a boundary of the power line 19, a partial boundary of the partition strip 32 extends outward in an extending direction of the boundary of the power line 19 to form a protruding portion 320, which covers a part of the boundary of the power line 19.

With such the arrangement, the boundary of the power line 19 located at the boundaries of the partition strips 32 can be prevented from being exposed with a great process deviation for forming the partition strips 32. The boundary of the power line 19 is covered by the passivation layer 25, but the passivation layer 25 may be over-etched in the process for forming the partition strips 32 to expose the power lines 19. The partition strips 32 may not effectively cover the power line 19 at the boundaries of the partition strips 32 due to the fluctuation in the process for forming the partition strips 32, and thus the boundary of the power line 19 at the boundaries of the partition strips 32 is exposed, and finally, the GDSX issue of the display substrate may be caused by the invasion of water vapor in the reliability process.

In some embodiments, referring to FIGS. 5a and 5b, a size of the protruding portion 320 in the extending direction of the boundary of the power line 19 is greater than or equal to 5µm. With such the size of the protruding portion 320, the boundary of the power line 19 located at the boundaries of the partition strips 32 can be completely prevented from being exposed with a great process deviation for forming the partition strips 32.

In some embodiments, the power line 19 may be a VDD power line or a VSS power line.

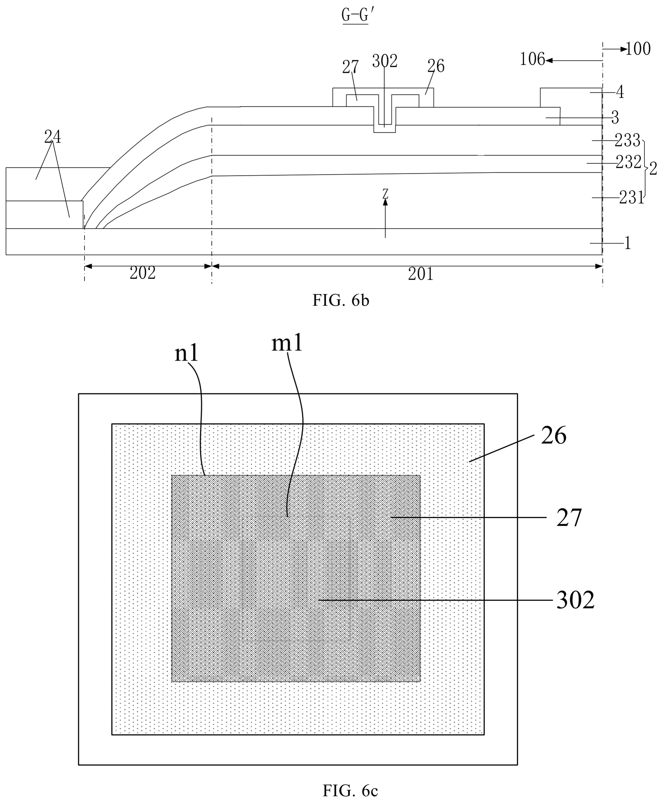

FIG. 6a is a schematic top view of a structure of a third region in a display substrate according to an embodiment of the present disclosure. FIG. 6b is a cross-sectional view of a structure taken along a section line GG' in FIG. 6a. In some embodiments, referring to FIG. 2a, the binding region 103 further includes a third region 106 located between the display region 100 and the second dam 24 closest to the display region 100, the planarization layer 2 and the pixel defining layer 4 respectively extend from the display region 100 to the third region 106, and the insulating layer 3 is further located in the third region 106. In the third region 106, cut-off boundaries a', b', c' of the pixel defining layer 4, the planarization layer 2, and the insulating layer 3 are sequentially arranged along a fifth direction T. In the third region 106, the cut-off boundaries a', b', c' of the pixel defining layer 4, the planarization layer 2, and the insulating layer 3 are boundaries on a side of the pixel defining layer 4, the planarization layer 2, and the insulating layer 3 close to the second dam 24. The fifth direction T is a direction of the third region 106 away from the display region 100 and close to the second dam 24.

In this embodiment, referring to FIGS. 6a and 6b, in the third region 106, the orthographic projection of the insulating layer 3 on the driving substrate 1 covers the cut-off boundary b' of the planarization layer 2, that is, an orthographic projection of the cut-off boundary c' of the insulating layer 3 on the driving substrate 1 and the orthographic projection of the planarization layer 2 on the driving substrate 1 do not overlap with each other, so that a greater segment gap for layers can be prevented from being formed in the planarization layer 2 located under the insulating layer 3 in the process for forming the insulating layer 3, the inorganic encapsulation layer for encapsulating the light-emitting devices formed above the display substrate can be prevented from cracking at the greater segment gap for layers, the water vapor can be further prevented from entering the OLED display panel from the crack position, and therefore, the GDSH and GDSX issues regarding the reliability of the display panel adopting the display substrate can be avoided.

In some embodiments, referring to FIGS. 6a and 6b, in the third region 106, the orthographic projection of the insulating layer 3 on the driving substrate 1 at least partially overlaps with the orthographic projection of the planarization layer 2 on the driving substrate 1, the insulating layer 3 is provided with a plurality of second vents 302 therein, orthographic projections of the plurality of second vents 302 on the driving substrate 1 are located in a region where the orthographic projection of the insulating layer 3 on the driving substrate 1 and the orthographic projection of the planarization layer 2 on the driving substrate 1 overlap with each other, and the plurality of second vents 302 are uniformly arranged. The display substrate further includes a plurality of third filling structures 26 disposed in the same layer and made of the same material as the pixel defining layer 4 and in one-to-one correspondence with the plurality of second vents 302, and an orthographic projection of each third filling structure 26 on the driving substrate 1 covers an orthographic projection of the corresponding second vent 302 on the driving substrate 1.

The planarization layer 2 is made of an organic insulating material, and the organic material of the planarization layer 2 needs to be deflated in the process for forming the planarization layer 2. The insulating layer 3 is made of an inorganic insulating material, such as silicon nitride, silicon oxide or silicon oxynitride. If the insulating layer 3 completely covers the planarization layer 2, the insulating layer 3 may be peeled off due to the deflating of the organic material in the process for forming the planarization layer 2, so that the resulting peeling particles pollute the display region 100, causing the failures. The second vents 302 are formed in the region of the insulating layer 3 overlapping with the planarization layer 2 in the third region 106, so that the insulating layer 3 can be prevented from impeding the deflating of the organic material, and therefore, the failures in the display substrate can be avoided. In addition, the third filling structures 26 may fill the segment gap for layers of the insulating layer 3 and the planarization layer 2 at the positions of the second vents 302, so that the inorganic encapsulation layer can be prevented from cracking at the greater segment gap for layers, the water vapor can be prevented from entering the OLED display panel from the crack position, and therefore, the GDSX issue regarding the reliability of the display panel adopting the display substrate can be avoided.

In some embodiments, referring to FIG. 6b, the planarization layer 2 in the third region 106 includes first climbing regions 202 and flat regions 201, which are sequentially arranged along the fifth direction T. The orthographic projections of the plurality of second vents 302 on the driving substrate 1 are located within orthographic projections of the flat regions 201 on the driving substrate 1. With such the arrangement, an uncontrollable greater segment gap for layers can be prevented from being formed in the planarization layer 2 under boundaries of the second vents 302 in the process for forming the second vents 302, the inorganic encapsulation layer can be prevented from cracking at the uncontrollable greater segment gap for layers, and the GDSX issue of the display substrate can be avoided.

In some embodiments, referring to FIG. 6b, in the third region 106, the planarization layer 2 includes a first sub-layer 231, a second sub-layer 232, and a third sub-layer 233, which are sequentially stacked in a direction away from the driving substrate 1, and each of which includes the first climbing region 202 and the flat region 201, and the flat region 201 and the first climbing region 202 of each of the first sub-layer 231, the second sub-layer 232, and the third sub-layer 233 are sequentially arranged along the fifth direction T. The orthographic projections of the plurality of second vents 302 on the driving substrate 1 are located in a region where orthographic projections of the flat regions 201 of at least two of the first sub-layer 231, the second sub-layer 232 and the third sub-layer 233 on the driving substrate 1 overlap with each other.

The orthographic projections of the plurality of second vents 302 on the driving substrate 1 are located in the region where the orthographic projections of the flat regions 201 of the at least two of the first sub-layer 231, the second sub-layer 232 and the third sub-layer 233 on the driving substrate 1 overlap with each other, so that it can be ensured that the positions where the second vents 302 are provided can avoid the first climbing region 202 of the third sub-layer 233 in the top, and therefore, an uncontrollable greater segment gap for layers can be prevented from being formed in the boundaries of the second vents 302 and the first climbing region 202 of the third sub-layer 233, the inorganic encapsulation layer can be prevented from cracking at the uncontrollable greater segment gap for layers, and the GDSX issue of the display substrate can be avoided..

In some embodiments, referring to FIG. 6b, the first climbing region 202 of the second sub-layer 232 is filled up by the first climbing region 202 of the third sub-layer 233, and the first climbing region 202 of the first sub-layer 231 is filled up by the first climbing region 202 of the second sub-layer 232.

FIG. 6c is a schematic top view of a second conductive pattern and a second vent in a display substrate according to an embodiment of the present disclosure. In some embodiments, referring to FIGS. 6a, 6b and 6c, the display substrate further includes a second conductive pattern 27 disposed in the same layer as the first conductive pattern 171 and located between the insulating layer 3 and the corresponding third filling structure 26, an orthographic projection of the second conductive pattern 27 on the driving substrate 1 at least covers a partial boundary m1 of the corresponding second vent 302, and an orthographic projection of a boundary n1 of the second conductive pattern 27 on the driving substrate 1 is located in the orthographic projection of the insulating layer 3 on the driving substrate 1. The orthographic projection of the third filling structure 26 on the driving substrate 1 covers the boundary m1 of the corresponding second vent 302 and the boundary n1 of the corresponding second conductive pattern 27.

The second conductive pattern 27 is easily undercut at the boundary of the second vent 302 due to the segment gap of the insulating layer 3, and the inorganic encapsulation layer is easily broken at this position due to a recess caused by the undercut, resulting in the risk of the GDSX regarding the reliability for the display substrate. In this embodiment, the third filling structure 26 is provided to cover the boundary m1 of the second vent 302 and the boundary n1 of the second conductive pattern 27, so that the segment gap for layers formed at the boundary m1 of the second vent 302 and the boundary n1 of the second conductive pattern 27 may be filled, the segment gap for layers at the boundary m1 of the second vent 302 and the boundary n1 of the second conductive pattern 27 is reduced or completely eliminated, and the inorganic encapsulation layer can be prevented from cracking at the segment gap for layers, thereby finally avoiding the risk of the GDSX regarding the reliability for the display substrate.

In some embodiments, referring to FIGS. 6a and 6b, the portion of the insulating layer 3 located in the display region 100 and the portion of the insulating layer 3 located in the third region 106 are separated from each other in the third region 106, and the orthographic projection of the pixel defining layer 4 on the driving substrate 1 covers at least a part of the separation boundary of the insulating layer 3.

The separation boundary of the insulating layer 3 is a boundary formed by separating a pattern of the portion of the insulating layer 3 located in the display region 100 and a pattern of the portion of the insulating layer 3 located in the third region 106 from each other in the third region 106. The pixel defining layer 4 extends from the display region 100 to the third region 106, the planarization layer 2 is laid under a broken position of the insulating layer 3. With such the arrangement, the pixel defining layer 4 may fill the greater segment gap for layers (including a segment gap for the thickness of the insulating layer 3 and a segment gap for the recess formed in the planarization layer 2 under the insulating layer 3) formed at the broken position of the insulating layer 3, so that the inorganic encapsulation layer can be prevented from cracking due to the greater segment gap for layers at the broken position of the insulating layer 3, the water vapor can be further prevented from entering the OLED display panel from the crack position, and therefore, the GDSX issue regarding the reliability of the display panel adopting the display substrate can be avoided.

In this embodiment, the orthographic projection of the boundary of the insulating layer on the driving substrate is located in the orthographic projection region of the flat region on the driving substrate, or the orthographic projection of the boundary of the insulating layer on the driving substrate does not overlap with the orthographic projection of the planarization layer on the driving substrate at the position or in the region in the display substrate where the orthographic projection of any first climbing region on the driving substrate does not overlap with the orthographic projection of the pixel defining layer on the driving substrate, so that the greater segment gap for layers can be prevented from being formed in the planarization layer under the insulating layer in the process for forming the insulating layer, the inorganic encapsulation layer for encapsulating the light-emitting devices formed on the display substrate can be prevented from cracking at the greater segment gap for layers, the water vapor can be prevented from entering the OLED display panel from the crack position, and therefore, the GDSH and GDSX issues regarding the reliability of the display panel adopting the display substrate can be avoided.

In a second aspect, an embodiment of the present disclosure provides a display panel, which includes the display substrate in the foregoing embodiments.

The display panel further includes an organic material layer, a cathode, an encapsulation layer and a polarizer, which are sequentially stacked on a side of the pixel defining layer in the display substrate away from the driving substrate. The organic material layer and the cathode entirely cover the display region. The organic material layer is located on a side of the pixel defining layer in the display substrate away from the driving substrate. The pixel defining layer is provided with an opening therein, the anode is exposed at the opening, and a portion of the organic material layer located in the opening of the pixel defining layer emits light under the action of an electric field formed between the anode and the cathode. The encapsulation layer is located on a side of the cathode away from the display substrate. The polarizer is located on a side of the encapsulation layer away from the display substrate. The anode is located in the display region. The pixel defining layer and the planarization layer extend from the display region to the hole peripheral region. The encapsulation layer and the polarizer extend from the display region to cover the hole peripheral region.

The display panel provided by the embodiment of the present disclosure, by adopting the display substrate in the above embodiments, can solve or avoid the GDSH and GDSX issues regarding the reliability and improve the quality of the display panel.

The display panel provided by the embodiment of the present disclosure may be any product or component with a display function, such as an OLED panel, an OLED television, an OLED billboard, a display, a mobile phone, a navigator or the like.

It should be understood that the above embodiments are merely exemplary embodiments adopted to explain the principles of the present disclosure, and the present disclosure is not limited thereto. It will be apparent to one of ordinary skill in the art that various changes and modifications may be made therein without departing from the spirit and scope of the present disclosure, and such changes and modifications also fall within the scope of the present disclosure.

## Claims

1. A display substrate, comprising a driving substrate, a planarization layer, an insulating layer, and a pixel defining layer, wherein the planarization layer, the insulating layer, and the pixel defining layer are sequentially stacked on one side of the driving substrate;
the planarization layer comprises a plurality of first climbing regions where a size of the planarization layer in a first direction gradually increases from 0 to a maximum value, and the first direction is a direction of the planarization layer away from the driving substrate;
an orthographic projection of the plurality of first climbing regions on the driving substrate and an orthographic projection of the pixel defining layer on the driving substrate at least partially do not overlap with each other; and
the insulating layer comprises at least one boundary, and an orthographic projection of at least part of the boundary of the insulating layer on the driving substrate is located outside an orthographic projection of the plurality of first climbing regions on the driving substrate.

2. A display substrate, comprising a driving substrate, a planarization layer, an insulating layer, and a pixel defining layer, wherein the planarization layer, the insulating layer, and the pixel defining layer are sequentially stacked on one side of the driving substrate;
the planarization layer comprises a flat region and a plurality of first climbing regions, and the flat region abuts on the plurality of first climbing regions, respectively;
an orthographic projection of the plurality of first climbing regions on the driving substrate and an orthographic projection of the pixel defining layer on the driving substrate at least partially do not overlap with each other,
a size of the planarization layer in a first direction gradually increases from 0 to a maximum value in the plurality of first climbing regions, a size of the planarization layer at any position in the first direction is approximately the maximum value in the flat region, and the first direction is a direction of the planarization layer away from the driving substrate; and
the insulating layer comprises at least one boundary, and an orthographic projection of at least part of the boundary of the insulating layer on the driving substrate is within the orthographic projection of the flat region on the driving substrate, or the orthographic projection of at least part of the boundary of the insulating layer on the driving substrate and an orthographic projection of the planarization layer on the driving substrate do not overlap with each other.

3. The display substrate of claim 2, wherein the display substrate comprises a display region, a hole region, and a hole peripheral region, the hole peripheral region at least partially surrounds the hole region, and the display region at least partially surrounds the hole peripheral region;
the planarization layer and the pixel defining layer extend from the display region to the hole peripheral region, respectively, and the insulating layer is located in the display region and the hole peripheral region;
cut-off boundaries of the pixel defining layer, the planarization layer, and the insulating layer are sequentially arranged along a second direction in the hole peripheral region, the cut-off boundaries of the pixel defining layer, the planarization layer, and the insulating layer are boundaries on a side of the pixel defining layer, the planarization layer, and the insulating layer close to the hole region in the hole peripheral region, respectively; and
the second direction is a direction of the hole peripheral region away from the display region and close to the hole region.

4. The display substrate of claim 3, wherein the insulating layer comprises a plurality of partition grooves therein in the hole peripheral region, and the plurality of partition grooves are sequentially arranged in the second direction at intervals and configured to partition the insulating layer into a plurality of partition portions.

5. The display substrate of claim 4, wherein an orthographic projection of each of the plurality of partition grooves on the driving substrate is closed and surrounds the hole region; and
an orthographic projection of each of the plurality of partition portions on the driving substrate is closed and surrounds the hole region.

6. The display substrate of claim 5, wherein the planarization layer comprises the first climbing region and the flat region in the hole peripheral region, and the flat region and the first climbing region are sequentially arranged along the second direction; and
an orthographic projection of the plurality of partition grooves on the driving substrate at least partially overlaps with the orthographic projection of the flat region on the driving substrate.

7. The display substrate of claim 5, wherein the insulating layer comprises two to five partition grooves.

8. The display substrate of claim 5, wherein the plurality of partition portions have a same width in the second direction.

9. The display substrate of claim 5, wherein the plurality of partition portions have different widths in the second direction.

10. The display substrate of claim 9, wherein a partition portion closest to the hole region is a first partition portion, a partition portion closest to the display region is a second partition portion, and at least one partition portion between the first partition portion and the second partition portion is at least one intermediate partition portion;
widths of the first partition portion and the second partition portion in the second direction are greater than a width of the intermediate partition portion in the second direction, respectively, and
the width of the second partition portion in the second direction is greater than the width of the first partition portion in the second direction.

11. The display substrate of claim 10, wherein the width of the first partition portion in the second direction is in a range of 81µm to 83µm;
the width of the second partition portion in the second direction is in a range of 85µm to 89µm; and
the width of the intermediate partition portion in the second direction is in a range of 75µm to 80µm.

12. The display substrate of claim 11, wherein the width of the first partition portion in the second direction is 81µm;
the width of the second partition portion in the second direction is 88µm; and
the width of the intermediate partition portion in the second direction is 80µm.

13. The display substrate of claim 8 or 9, wherein the width of each partition portion in the second direction is not less than 10µm.

14. The display substrate of any one of claims 4 to 12, wherein a width of each partition groove in the second direction is less than a width of each partition portion in the second direction.

15. The display substrate of claim 14, wherein the width of each partition groove in the second direction is in a range of 3µm to 10µm.

16. The display substrate of claim 10, wherein a boundary of the first partition portion close to the hole region is the cut-off boundary of the insulating layer, and
a distance between an orthographic projection of the cut-off boundary of the insulating layer on the driving substrate and an orthographic projection of the cut-off boundary of the planarization layer on the driving substrate is greater than or equal to 3.5µm and less than the width of the first partition portion in the second direction.

17. The display substrate of claim 10, wherein a portion of the insulating layer located in the display region and a portion of the insulating layer located in the hole peripheral region are separated from each other in the hole peripheral region, and
the orthographic projection of the pixel defining layer on the driving substrate covers at least a part of a separation boundary of the insulating layer.

18. The display substrate of claim 17, wherein a boundary of the second partition portion close to the hole region is located on a side of the cut-off boundary of the pixel defining layer close to the hole region, and
a distance between an orthographic projection of the boundary of the second partition portion close to the hole region on the driving substrate and an orthographic projection of the cut-off boundary of the pixel defining layer on the driving substrate is greater than or equal to 3µm and less than the width of the second partition portion in the second direction.

19. The display substrate of claim 18, wherein the distance between the orthographic projection of the boundary of the second partition portion close to the hole region on the driving substrate and the orthographic projection of the cut-off boundary of the pixel defining layer on the driving substrate is greater than or equal to 5µm.

20. The display substrate of claim 3, wherein the driving substrate comprises a substrate, a plurality of conductive layers and a plurality of inorganic insulating layers;
the plurality of conductive layers and the plurality of inorganic insulating layers are sequentially and alternately stacked on a side of the substrate close to the planarization layer;
the substrate extends from the display region to the hole peripheral region;
the plurality of conductive layers are located in the display region, and at least a part of the conductive layers are located in the hole peripheral region;
the plurality of inorganic insulating layers extend from the display region to the hole peripheral region;
the display substrate further comprises a plurality of first isolation pillars, a first dam and a plurality of second isolation pillars, which are located in the hole peripheral region and are sequentially arranged at intervals along the second direction;
each of the plurality of first isolation pillars and the plurality of second isolation pillars comprises at least one conductive layer;
the first dam comprises a first sub-layer in the same layer and made of the same material as the planarization layer and a second sub-layer in the same layer and made of the same material as the pixel defining layer, and the first sub-layer and the second sub-layer are sequentially stacked together; and
the plurality of first isolation pillars, the first dam and the plurality of second isolation pillars are located on a side of the cut-off boundary of the insulating layer close to the hole region, and orthographic projections of the plurality of first isolation pillars, the first dam and the plurality of second isolation pillars on the substrate do not overlap with an orthographic projection of the insulating layer on the substrate.

21. The display substrate of claim 20, wherein a distance between the cut-off boundary of the insulating layer and a boundary of a first isolation pillar closest to the cut-off boundary of the insulating layer is greater than or equal to 4µm.

22. The display substrate of claim 6, wherein the planarization layer comprises a plurality of sub-layers, which are sequentially stacked together;
the display substrate further comprises a plurality of first wiring lines in the hole peripheral region and between two adjacent sub-layers, orthographic projections of at least part of the first wiring lines on the driving substrate are located in the flat region, and
orthographic projections of the plurality of first wiring lines and the plurality of partition grooves on the driving substrate do not overlap with each other.

23. The display substrate of claim 22, wherein a distance between orthographic projections of adjacent boundaries of each first wiring line and the partition grooves on the driving substrate is greater than 1µm.

24. The display substrate of claim 4, wherein an orthographic projection of the plurality of partition portions on the driving substrate and the orthographic projection of the planarization layer on the driving substrate at least partially overlap with each other;
each of the partition portion comprises a plurality of first vents, orthographic projections of the plurality of first vents on the driving substrate are located in a region where the orthographic projection of the partition portion on the driving substrate and the orthographic projection of the planarization layer on the driving substrate at least partially overlap with each other, and the plurality of first vents are uniformly arranged in the partition portion;
the display substrate further comprises a plurality of first filling structures in the same layer and made of the same material as the pixel defining layer; and
the plurality of first filling structures are in one-to-one correspondence with the plurality of first vents, and an orthographic projection of each first filling structure on the driving substrate covers its corresponding first vent.

25. The display substrate of claim 24, wherein a distance between corresponding boundaries of orthographic projections of the first filling structure and the first vent corresponding to each other on the driving substrate is greater than or equal to 5µm.

26. The display substrate of claim 25, wherein a shape of the orthographic projection of each first vent on the driving substrate comprises a triangle, a rectangle, a circle, an ellipse, or a polygon, and
a shape of the orthographic projection of each first filling structure on the driving substrate comprises a triangle, a rectangle, a circle, an ellipse, or a polygon.

27. The display substrate of claim 26, wherein an area of the orthographic projection of each first vent on the driving substrate is in a range from 3×3µm² to 10×10µm².

28. The display substrate of claim 3, wherein the display substrate comprises at least one hole region; and
each hole region has a shape comprising a circle, an ellipse, a capsule shape or an inverted trapezoid.

29. The display substrate of claim 20, wherein the display substrate further comprises a binding region on one side of the display region, and the binding region comprises a first region;
at least a part of the conductive layer is located in the first region, and the insulating layer is further located in the first region;
the display substrate further comprises a power electrode located in the first region;
the power electrode comprises a first conductive pattern and at least one conductive layer, and the at least one conductive layer and the first conductive pattern are sequentially stacked in a direction away from the driving substrate;
the first conductive pattern is located on a side of the insulating layer away from the driving substrate and partially overlaps with the insulating layer; and
an orthographic projection of the first conductive pattern on the driving substrate covers at least a portion of an overlapping boundary of the insulating layer overlapping with the first conductive pattern, and an orthographic projection of an overlapping boundary of the first conductive pattern overlapping with the insulating layer on the driving substrate is at least partially located in the orthographic projection of the insulating layer on the driving substrate.

30. The display substrate of claim 29, wherein a region where the orthographic projection of the first conductive pattern on the driving substrate overlaps with the orthographic projection of the insulating layer on the driving substrate has a width greater than or equal to 3 µm.

31. The display substrate of claim 30, further comprising a second filling structure in the first region, and arranged in the same layer and made of the same material as the pixel defining layer;
wherein an orthographic projection of the second filling structure on the driving substrate covers a first boundary of the insulating layer overlapping with the first conductive pattern and a second boundary of the first conductive pattern overlapping with the insulating layer;
a distance between an orthographic projection of the first boundary on the driving substrate and an orthographic projection of a boundary of the second filling structure on a side of the first boundary away from the insulating layer on the driving substrate is greater than or equal to 5µm; and
a distance between an orthographic projection of the second boundary on the driving substrate and an orthographic projection of a boundary of the second filling structure on a side of the second boundary away from the first conductive pattern on the driving substrate is greater than or equal to 10µm.

32. The display substrate of claim 29, wherein the binding region further comprises a second region;
at least a part of the conductive layer is located in the second region, and the insulating layer further comprises a plurality of partition strips in the second region;
the display substrate further comprises a power line and a plurality of second dams, at least a part of which are located in the second region;
in the second region, the plurality of partition strips and the plurality of second dams extend along a third direction, respectively, and are sequentially and alternately arranged along a fourth direction;
the planarization layer and the pixel defining layer further extend to the second region;
the plurality of second dams each comprise a third sub-layer in the same layer and made of the same material as the planarization layer, and a fourth sub-layer in the same layer and made of the same material as the pixel defining layer, and the third sub-layer and the fourth sub-layer are sequentially stacked together;
the power line comprises at least one conductive layer, and extends in the fourth direction;
the third direction intersects with the fourth direction;
an orthographic projection of the power line on the driving substrate intersects with orthographic projections of the plurality of partition strips and the plurality of second dams on the driving substrate;
a passivation layer is arranged between the power line and the plurality of partition strips and is configured to cover the second region; and
an edge region of each partition strip overlaps with the plurality of second dams, the planarization layer, and the pixel defining layer, and a portion of each partition strip other than the edge region is in contact with the passivation layer.

33. The display substrate of claim 32, wherein a width of the edge region of each partition strip overlapping with the pixel defining layer in the fourth direction is greater than or equal to 5µm.

34. The display substrate of claim 32, wherein orthographic projections of the boundaries of the plurality of partition strips on the planarization layer are located in the flat region.

35. The display substrate of any one of claims 32 to 34, wherein in a region where each partition strip overlaps with a boundary of the power line, a part of the boundary of the partition strip extends outward in an extending direction of the boundary of the power line to form a protruding portion, which covers a part of the boundary of the power line.

36. The display substrate of claim 35, wherein a size of the protruding portion in the extending direction of the boundary of the power line is greater than or equal to 5µm.

37. The display substrate of claim 32, wherein the binding region further comprises a third region between the display region and the second dam closest to the display region;
the planarization layer and the pixel defining layer extend from the display region to the third region, respectively, and the insulating layer is further located in the third region;
in the third region, cut-off boundaries of the pixel defining layer, the planarization layer, and the insulating layer are sequentially arranged along a fifth direction, and in the third region, the cut-off boundaries of the pixel defining layer, the planarization layer, and the insulating layer are boundaries on a side of the pixel defining layer, the planarization layer, and the insulating layer close to the second dam; and
the fifth direction is a direction of the third region away from the display region and close to the second dam.

38. The display substrate of claim 37, wherein in the third region, the orthographic projection of the insulating layer on the driving substrate at least partially overlaps with the orthographic projection of the planarization layer on the driving substrate;
the insulating layer comprises a plurality of second vents, orthographic projections of the plurality of second vents on the driving substrate are located in a region where the orthographic projection of the insulating layer on the driving substrate and the orthographic projection of the planarization layer on the driving substrate overlap with each other, and the plurality of second vents are uniformly arranged in the insulating layer;
the display substrate further comprises a plurality of third filling structures in the same layer and made of the same material as the pixel defining layer; and
the plurality of third filling structures are in one-to-one correspondence with the plurality of second vents, and an orthographic projection of each third filling structure on the driving substrate covers an orthographic projection of its corresponding second vent on the driving substrate.

39. The display substrate of claim 38, wherein the planarization layer in the third region comprises a first climbing region and a flat region, which are sequentially arranged along the fifth direction; and
the orthographic projections of the plurality of second vents on the driving substrate are located within an orthographic projection of the flat region on the driving substrate.

40. The display substrate of claim 38, wherein the planarization layer in the third region comprises a first sub-layer, a second sub-layer, and a third sub-layer, which are sequentially stacked together in a direction away from the driving substrate;
each of the first sub-layer, the second sub-layer, and the third sub-layer comprises the first climbing region and the flat region, and the flat region and the first climbing region of each of the first sub-layer, the second sub-layer, and the third sub-layer are sequentially arranged along the fifth direction; and
the orthographic projections of the plurality of second vents on the driving substrate are located in a region where orthographic projections of the flat regions of at least two of the first sub-layer, the second sub-layer and the third sub-layer on the driving substrate overlap with each other.

41. The display substrate of claim 38, further comprising a second conductive pattern, which is arranged in the same layer as the first conductive pattern and between the insulating layer and its corresponding third filling structure of the plurality of third filling structures;
an orthographic projection of the second conductive pattern on the driving substrate at least covers an orthographic projection of a part of a boundary of its corresponding second vent of the plurality of second vents on the driving substrate;
an orthographic projection of a boundary of the second conductive pattern on the driving substrate is located in the orthographic projection of the insulating layer on the driving substrate; and
the orthographic projection of the third filling structure on the driving substrate covers orthographic projections of the boundary of the corresponding second vent and the boundary of the corresponding second conductive pattern on the driving substrate.

42. The display substrate of claim 37, wherein a portion of the insulating layer located in the display region and a portion of the insulating layer located in the third region are spaced apart from each other in the third region, and
the orthographic projection of the pixel defining layer on the driving substrate covers at least a part of a separation boundary of the insulating layer.

43. The display substrate of claim 2, wherein each first climbing region has a slope angle in a range from 15° to 80°.

44. The display substrate of claim 6, wherein an orthographic projection of each first climbing region on the driving substrate has a width in a range of 1µm to 30µm along the second direction.

45. A display panel, comprising the display substrate of any one of claims 1 to 44.
